(19) **Europäisches Patentamt / European Patent Office / Office européen des brevets**

(11) **EP 2 784 871 B1**

(12) **EUROPEAN PATENT SPECIFICATION**

(45) Date of publication and mention of the grant of the patent:
**11.10.2017 Bulletin 2017/41**

(21) Application number: **12852301.6**

(22) Date of filing: **15.08.2012**

(51) Int Cl.:
*H01M 14/00* (2006.01)          *H01L 31/04* (2014.01)
*H01G 9/20* (2006.01)           *H01L 51/00* (2006.01)

(86) International application number:
**PCT/JP2012/070741**

(87) International publication number:
**WO 2013/077043 (30.05.2013 Gazette 2013/22)**

(54) **PHOTOELECTRODE FOR DYE-SENSITIZED SOLAR CELL, AND METHOD FOR MANUFACTURING PHOTOELECTRODE FOR DYE-SENSITIZED SOLAR CELL, AND DYE-SENSITIZED SOLAR CELL**

FOTOLEKETRODE FÜR FARBSTOFFSENSIBILISIERTE SOLARZELLE UND VERFAHREN ZUR HERSTELLUNG EINER FOTOELEKTRODE FÜR EINE FARBSTOFFSENSIBILISIERTE SOLARZELLE SOWIE FARBSTOFFSENSIBILISIERTE SOLARZELLE

PHOTOÉLECTRODE POUR CELLULE SOLAIRE À COLORANT, SON PROCÉDÉ DE FABRICATION ET CELLULE SOLAIRE À COLORANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.11.2011   JP 2011257467**
**23.03.2012   JP 2012067090**
**28.03.2012   JP 2012073146**
**16.05.2012   JP 2012112713**
**27.07.2012   JP 2012167351**

(43) Date of publication of application:
**01.10.2014   Bulletin 2014/40**

(73) Proprietors:
• **Tokyo University Of Science Educational Foundation Administrative Organization**
**Shinjuku-ku**
**Tokyo 162-8601 (JP)**
• **Toppan Printing Co., Ltd.**
**Tokyo 110-8560 (JP)**

(72) Inventors:
• **WATANABE Naoya**
**Tokyo 162-8601 (JP)**
• **KUDOU Tomohiro**
**Tokyo 162-8601 (JP)**
• **OZAWA Hironobu**
**Tokyo 162-8601 (JP)**
• **ARAKAWA Hironori**
**Tokyo 162-8601 (JP)**
• **SHIBAYAMA Naoyuki**
**Tokyo 110-8560 (JP)**

(74) Representative: **TBK**
**Bavariaring 4-6**
**80336 München (DE)**

(56) References cited:
WO-A1-2010/008294     JP-A- 2008 027 860
JP-A- 2008 288 209     JP-A- 2011 142 010

• **HENRIK LINDSTRÖM ET AL: "A New Method for Manufacturing Nanostructured Electrodes on Plastic Substrates", NANO LETTERS, vol. 1, no. 2, 17 January 2001 (2001-01-17), pages 97-100, XP055107773, US ISSN: 1530-6984, DOI: 10.1021/nl0055254**
• **FRANCK PLOURABOUÉ ET AL: "Multi-scale roughness transfer in cold metal rolling", TRIBOLOGY INTERNATIONAL, vol. 32, no. 1, 1 January 1999 (1999-01-01), pages 45-57, XP055185674, ISSN: 0301-679X, DOI: 10.1016/S0301-679X(99)00013-4**

- **SANTA-NOKKI H ET AL: "Dynamic preparation of TiO2 films for fabrication of dye-sensitized solar cells", JOURNAL OF PHOTOCHEMISTRY AND PHOTOBIOLOGY, A: CHEMISTRY, ELSEVIER SEQUOIA, LAUSANNE, CH, vol. 182, no. 2, 31 August 2006 (2006-08-31), pages 187-191, XP028008381, ISSN: 1010-6030, DOI: 10.1016/J.JPHOTOCHEM.2006.02.011 [retrieved on 2006-08-31]**
- **CHOU C S ET AL: "Preparation of TiO2/dye composite particles and their applications in dye-sensitized solar cell", POWDER TECHNOLOGY, ELSEVIER SEQUOIA, LAUSANNE, CH, vol. 187, no. 2, 28 October 2008 (2008-10-28), pages 181-189, XP025504629, ISSN: 0032-5910, DOI: 10.1016/J.POWTEC.2008.02.010 [retrieved on 2008-03-07]**

Remarks:

The file contains technical information submitted after the application was filed and not included in this specification

**Description**

TECHNICAL FIELD

The present invention relates to a photoelectrode for a dye-sensitized solar cell, a method for manufacturing the same, and a dye-sensitized solar cell.

BACKGROUND ART

A dye-sensitized solar cell was developed by Graetzel et al. of Switzerland, and has merits of high conversion efficiency compared to other ordinary cells, low manufacturing costs, and the like. As the dye-sensitized solar cell, for example, the configurations described in Non Patent Document 1 and Patent Document 1 are known.

The dye-sensitized solar cell disclosed in Patent Document 1 is formed by laminating a translucent substrate made by forming a transparent conductive layer on a plastic translucent support (base material), a photoelectric conversion layer (an oxide semiconductor porous membrane supporting a sensitizing dye (a sensitizer)) disposed on the translucent substrate, an electrolyte portion and a counter electrode.

The photoelectric conversion layer of the above components is formed using processes described below. First, aqueous paste containing at least two kinds of titania particles having different average particle diameters is applied to the translucent support so as to form a coated film, and then the coated film is pressed, thereby forming a layer. In addition, the photoelectric conversion layer is formed by allowing the formed layer to support the sensitizer.

According to the dye-sensitized solar cell configured as described above, even in a case in which plastic is used for the translucent support, it is possible to increase the conversion efficiency by forming the photoelectric conversion layer on the translucent support by increasing adhesiveness, and it is possible to obtain the same degree of performance as a dye-sensitized solar cell in which a glass transparent substrate is used (for example, Non Patent Document 2).

PRIOR ART DOCUMENTS

PATENT DOCUMENTS

[Patent Document 1] PCT International Publication No. WO 2007/100095
[Patent Document 2] Japanese Unexamined Patent Application, First Publication No. 2011-142010

NON-PATENT DOCUMENTS

[Non Patent Document 1] Nature, 353, p. 737 to 740, 1991
[Non Patent Document 2] SOL. Energy Mater. Sol. Cel. 94, 812, 2010

DISCLOSURE OF INVENTION

PROBLEMS TO BE SOLVED BY THE INVENTION

However, in the manufacturing methods of Patent Document 1 and Non Patent Document 2, since it takes an excessive amount of time to manufacture a photoelectrode for a dye-sensitized solar cell including the photoelectric conversion layer, it is necessary to develop a method that can manufacture the photoelectrode continuously in order for the manufacturing methods to be industrially used.

In consideration of the above problem, an object of the present invention is to provide a photoelectrode for a dye-sensitized solar cell, which can be produced at a high speed and reduces the manufacturing costs, and a method for manufacturing the same.

Another object of the present invention is to provide a dye-sensitized solar cell which can be produced at a high speed and reduces the manufacturing costs.

Prior art which is related to this field of technology can be found e.g. in document Henrik Lindström ET AL: "A New Method for Manufacturing Nanostructured Electrodes on Plastic Substrates", Nano Letters, vol. 1 no. 2, 7 January 2001, pages 97-100, in document Franck Plouraboué ET AL: "Multi-scale roughness transfer in cold metal rolling", Tribology International, vol. 32, no. 1, 1 January 1999, pages 45-57, in document SANTA-NOKKI H ET AL: "Dynamic preparation of TiO2 films for fabrication of dye-sensitized solar cells", JOURNAL OF PHOTOCHEMISTRY AND PHOTOBIOLOGY, A: CHEMISTRY, ELSEVIER SEQUOIA, LAUSANNE CH, vol. 182, no. 2, 31. August 2006 pages 187-191, in document WO 2010/008294 A1 disclosing reversed dye-sensitized photovoltaic cell, in document CHOU C S ET AL: " Preparation of TiO2/dye composite particles and their applications in dye-sensitized solar cell", POWDER TECHNOLOGY ELSEVIER SEQUOIA, LAUSANNE, CH, vol. 187, no. 2, 28 October 2008, pages 181-189, and in document JP 2011 142010 A disclosing manufacturing method of photoelectrode for dye-sensitized solar cell.

MEANS FOR SOLVING THE PROBLEMS

According to aspects of the present invention there are provided, a photoelectrode for a dye-sensitized solar cell and a method for manufacturing a photoelectrode for a dye-sensitized solar cell according to the respective claims.
According to a first embodiment of the present invention, a photoelectrode for a dye-sensitized solar cell of the present invention is a photoelectrode for a dye-sensitized solar cell including a sensitizer supported in a functional semiconductor layer of a photoelectrode structure provided with the functional semiconductor layer on a transparent conductive layer of a translucent substrate or on a metal substrate, the translucent substrate being made by forming the transparent conductive layer on a plastic translucent support, wherein the functional semiconductor layer includes a roll-pressed layer in contact with the transparent conductive layer or the metal substrate and roll-pressing traces extending in parallel with a roll-pressing treatment direction on a surface of the roll-pressed layer, and a surface roughness Ra in a first direction which is in parallel with the roll-pressing treatment direction is smaller than a surface roughness Ra in a second direction which is orthogonal to the first direction on a surface of the functional semiconductor layer, and the surface roughness Ra in the second direction is greater than or equal to 1.2 times the surface roughness Ra in the first direction.
In addition, a thickness of the roll-pressed layer of the functional semiconductor layer may be within 1$\mu$m to 40 $\mu$m.
In addition, the functional semiconductor layer may be roll-pressed under a pressure of 5 MPa to 500 MPa.
In the photoelectrode for a dye-sensitized solar cell of the present invention, the functional semiconductor layer may contain particles having the average particle diameter of 2 nm to 40 nm.
In addition, the functional semiconductor layer may contain two or more kinds of particles having different average particle diameters, and an average particle diameter of at least one kind of particles may be 2 nm to 40 nm.
At this time, in the two or more kinds of particles having different average particle diameters, a content ratio of particles having an average particle diameter of 2 nm to 40 nm may be 50 mass% to 95 mass%.
According to a second aspect of the present invention, a dye-sensitized solar cell including the photoelectrode for a dye-sensitized solar cell of the present invention is provided, in which the photoelectrode for a dye-sensitized solar cell is provided so as to face a counter electrode through an electrolyte portion.
According to a third aspect of the present invention, a method for manufacturing a photoelectrode for a dye-sensitized solar cell formed by laminating a photoelectric conversion layer on a transparent conductive layer of a translucent substrate or on a metal substrate, the translucent substrate being produced by forming the transparent conductive layer on a plastic translucent support, the photoelectric conversion layer containing particles and a sensitizer, the method including forming a coated film by applying paste containing the particles to the transparent conductive layer or the metal substrate, and then roll-pressing the coated film under a pressure of 5 MPa to 500 MPa, allowing a layer obtained by roll-pressing the coated film to support the sensitizer, and forming roll-pressing traces having different surface roughnesses Ra on a surface of the coated film in a first direction and a second direction, the first direction being in parallel with a roll-pressing treatment direction, the second direction being orthogonal to the first direction when roll-pressing the coated film, the surface roughness Ra in the second direction being greater than or equal to 1.2 times the surface roughness Ra in the first direction.

Effects of Invention

According to the photoelectrode for a dye-sensitized solar cell and the method for manufacturing the same of the present invention, it is possible to produce the photoelectrodes for a dye-sensitized solar cell at a high speed and to reduce the manufacturing costs.
The dye-sensitized solar cell of the present invention can be produced at a high speed, and can reduce the manufacturing costs.

BRIEF DESCRIPTION OF THE DRAWINGS

FIG. 1 is an explanatory cross-sectional view illustrating an example of a configuration of a cell that configures a dye-sensitized solar cell of a first embodiment of the present invention.

FIG. 2A is an explanatory cross-sectional view illustrating an example of a method for manufacturing a photoelectrode for a dye-sensitized solar cell of the dye-sensitized solar cell.

FIG. 2B is an explanatory cross-sectional view illustrating an example of a method for manufacturing a photoelectrode for a dye-sensitized solar cell of the dye-sensitized solar cell.

FIG. 2C is an explanatory cross-sectional view illustrating an example of a method for manufacturing a photoelectrode for a dye-sensitized solar cell of the dye-sensitized solar cell.

FIG. 2D is an explanatory cross-sectional view illustrating an example of a method for manufacturing a photoelectrode for a dye-sensitized solar cell of the dye-sensitized solar cell.

FIG. 3 is an explanatory cross-sectional view illustrating an example of a configuration of a cell that configures a dye-sensitized solar cell of a second embodiment of the present invention.

FIG. 4A is an explanatory cross-sectional view illustrating an example of a method for manufacturing a photoelectrode for a dye-sensitized solar cell of the dye-sensitized solar cell.

FIG. 4B is an explanatory cross-sectional view illustrating an example of a method for manufacturing a photoelectrode for a dye-sensitized solar cell of the dye-sensitized solar cell.

FIG. 4C is an explanatory cross-sectional view illustrating an example of a method for manufacturing a photoelectrode for a dye-sensitized solar cell of the dye-sensitized solar cell.

FIG. 4D is an explanatory cross-sectional view illustrating an example of a method for manufacturing a photoelectrode for a dye-sensitized solar cell of the dye-sensitized solar cell.

FIG. 4E is an explanatory cross-sectional view illustrating an example of a method for manufacturing a photoelectrode for a dye-sensitized solar cell of the dye-sensitized solar cell.

FIG. 4F is an explanatory cross-sectional view illustrating an example of a method for manufacturing a photoelectrode for a dye-sensitized solar cell of the dye-sensitized solar cell.

FIG. 5 is an explanatory cross-sectional view illustrating an example of a configuration of a cell that configures a dye-sensitized solar cell of a third embodiment of the present invention.

FIG. 6 is an explanatory cross-sectional view illustrating another example of a configuration of a cell that configures a dye-sensitized solar cell of a modified example of the present invention.

FIG. 7 is an enlarged photograph of a photoelectric conversion layer in a first example of the present invention.

FIG. 8 is an enlarged photograph of a photoelectric conversion layer in a comparative example.

FIG. 9 is a view for explaining a method for measuring a surface roughness Ra in the present invention.

FIG. 10 is a view for explaining a method for measuring the surface roughness Ra in the present invention.

## EMBODIMENTS FOR CARRYING OUT THE INVENTION

Hereinafter, the present invention will be specifically described. In the present specification, a numeric range expressed in a format of "A to B" means A or more and B or less (A<B) unless particularly otherwise described.

<First embodiment>

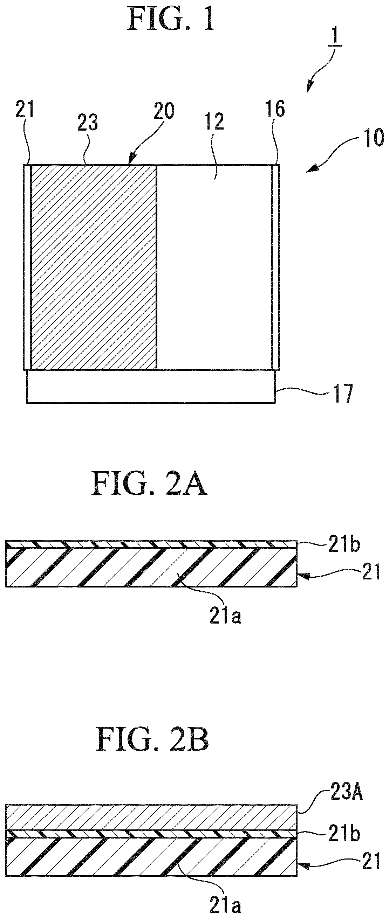

FIG. 1 is an explanatory cross-sectional view illustrating an example of a configuration of a cell 10, which is a configuration unit of a dye-sensitized solar cell 1 of a first embodiment of the present invention.

[Photoelectric conversion element]

In the cell 10 (hereinafter also referred to as "photoelectric conversion element") that configures the dye-sensitized solar cell 1, a photoelectrode for a dye-sensitized solar cell 20 (hereinafter also referred to simply as "photoelectrode") having a photoelectric conversion layer 23 formed on a translucent substrate 21 and a counter electrode 16 having a conductive layer (not shown) formed of, for example, platinum on a translucent substrate (not shown) are disposed so that the photoelectric conversion layer 23 and the conductive layer face each other through an electrolyte portion 12. When the photoelectrode 20 and the counter electrode 16 are connected using a connection wire 17, an electric current can be drawn outside.

The photoelectrode 20 serves as a negative electrode of the dye-sensitized solar cell 1, and specifically includes the translucent substrate 21 having a translucent support 21a and a transparent conductive layer 21b (refer to FIG. 2A), and the photoelectric conversion layer 23 laminated on the transparent conductive layer 21b.

[Photoelectric conversion layer]

The photoelectric conversion layer 23 is a roll-pressed layer containing semiconductor particles (sometimes referred to as "specific semiconductor particle group") and a sensitizer, and, specifically, has the sensitizer supported in a functional semiconductor layer 23$\alpha$ in which a coated film 23A (refer to FIG. 2B) of paste containing the specific semiconductor particle group is roll-pressed.

Since the photoelectric conversion layer 23 includes the roll-pressed functional semiconductor layer 23$\alpha$, a number of nano-fine pores can be formed in the functional semiconductor layer 23$\alpha$, and therefore the ratio of the surface area of the semiconductor particles per unit area of the substrate 21 becomes extremely large, whereby a sufficient amount of the sensitizer can be supported, and, consequently, a high light absorption efficiency can be obtained.

The photoelectric conversion layer 23 may be configured by providing semiconductor fine particles having an average particle diameter of 2 nm to 40 nm.

For example, in a case in which nano-sized semiconductor fine particles having an average particle diameter of approximately 20 nm are used (a case in which an optical confinement effect described below is not sufficiently used), a photoelectric conversion layer having a high transmittance can be produced.

In addition, when two or more kinds of semiconductor particles having different average particle diameters are provided in the photoelectric conversion layer 23, while the nano-sized semiconductor particles having, for example, an average particle diameter of approximately 20 nm have a tendency to easily transmit light with a long wavelength, since semiconductor particles having a large particle diameter, for example, an average particle diameter of approximately 100 nm, are present together with the nano-sized semiconductor particles, a so-called optical confinement effect, in which light is scattered and the length of light path increases in the functional semiconductor layer 23$\alpha$, can be sufficiently obtained. As a result, sufficient light absorption efficiency can be obtained for the sensitizer, and therefore a high conversion efficiency can be achieved in the dye-sensitized solar cell.

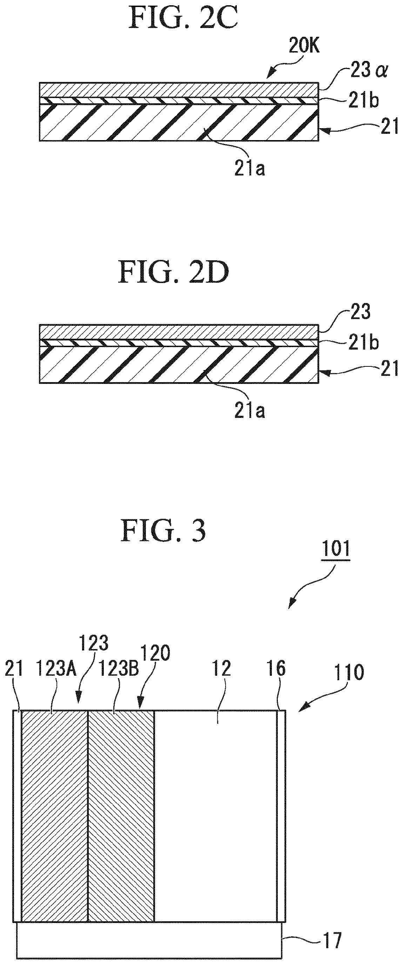

In the photoelectric conversion element 10, a photoelectrode structure 20K (refer to FIG. 2C) provided with the transparent conductive layer 21b and the functional semiconductor layer 23$\alpha$ in this order on the translucent support 21a preferably has a light transmittance of 20% to 65% at a wavelength of 500 nm, and a light transmittance of 30% to 75% at a wavelength of 700 nm. When the light transmittance is too large, since light transmits through the photoelectrode structure without internal scattering, there is a concern that it may become impossible to obtain sufficient light absorption efficiency in the photoelectrode 20, and, on the other hand, when the light transmittance is too small, there is a concern that light may be reflected on the surface and no light may enter the photoelectrode.

[Semiconductor particles]

The semiconductor particles have an electron transport action, and specific examples of semiconductors that configure the semiconductor particles include oxide semiconductors, such as $TiO_2$ SnO, ZnO, $WO_3$, $Nb_2O_5$, $In_2O_3$, $ZrO_2$ $Ta_2O_5$ and $TiSrO_3$; sulfide semiconductors, such as CdS, ZnS, $In_2S$, PbS, $Mo_2S$, $WS_2$, $Sb_2S_3$, $Bi_2S_3$, $ZnCdS_2$ and $CuS_2$; metal chalcogenides, such as CdSe, $In_2Se_2$, $WSe_2$, PbSe and CdTe; element semiconductors, such as GaAs, Si, Se and InP; and the like. It is also possible to use a complex made from two or more of the above semiconductors, for example, a complex of SnO and ZnO, and a complex of $TiO_2$ and $Nb_2O_5$. The kind of semiconductors is not limited to the above, and it is also possible to combine two or more semiconductors and use the combination.

As the semiconductor that configures the semiconductor particles, among the above, oxides of Ti, Zn, Sn and Nb are preferable, and $TiO_2$ is particularly preferable.

Examples of titania particles made of $TiO_2$ include anatase crystal-type titania particles and rutile crystal-type titania particles, both types can be used, and the anatase crystal-type titania particles are particularly preferably used.

In a case in which two or more kinds of semiconductor particles having different average particle diameters are provided to the specific semiconductor particle group, the semiconductor particles may be the same kind or different kinds, but are preferably the same kind.

As the semiconductor particles, titania particles are preferably used.

Among the semiconductor particles that configure the specific semiconductor particle group containing two or more kinds of semiconductor particles, the semiconductor particles having a small average particle diameter (hereinafter also referred to as "small semiconductor particles") have an average particle diameter of preferably 2 nm to 40 nm and more preferably 15 nm to 25 nm. In addition, the semiconductor particles having a large average particle diameter (hereinafter also referred to as "large semiconductor particles") have a light-scattering function and have an average particle diameter of preferably 50 nm or more, more preferably 80 nm to 400 nm, and particularly preferably 90 nm to 120 nm.

Hereinafter, the expressions of mass% and weight% (wt%) will be used, but both expressions may be understood to have substantially the same meaning unless particularly otherwise described.

The content ratio of the small semiconductor particles in the specific semiconductor particle group that configures the photoelectric conversion layer 23 is preferably 50 mass% to 95 mass%, and more preferably 60 mass% to 70 mass%. When the ratio of the small semiconductor particles is too large, the optical confinement effect of the large semiconductor particles cannot be obtained, and a high light absorption efficiency of the sensitizer cannot be obtained. On the other hand, when the ratio of the small semiconductor particles is too small, it is not possible to sufficiently obtain the photoelectric conversion function.

In addition, the thickness of the functional semiconductor layer $23\alpha$ that forms the photoelectric conversion layer 23 is preferably within 1 $\mu$m to 40 $\mu$m, more preferably within 3 $\mu$m to 30 $\mu$m, and still more preferably within 3 $\mu$m to 20 $\mu$m.

In a case in which the thickness of the functional semiconductor layer that forms the photoelectric conversion layer is too small, since a sufficient amount of the sensitizer cannot be supported, it becomes impossible for the obtained dye-sensitized solar cell to obtain sufficient conversion efficiency. On the other hand, in a case in which the thickness of the functional semiconductor layer that forms the photoelectric conversion layer is too large, since the diffusion distance of electrons injected from the sensitizer increases in the obtained photoelectric conversion layer, energy loss caused by the recombination of charges increases.

[Sensitizing dye (sensitizer)]

The sensitizer supported by the semiconductor particles in the photoelectric conversion layer 23 is not particularly limited as long as the sensitizer exhibits a sensitization action, and examples thereof include Ru complexes, such as N3 complex, N719 complex (N719 dye), Ru terpyridine complex (black dye) and Ru diketonate complex; organic dyes, such as coumarin-based dyes, merocyanine-based dyes and polyene-based dyes; metalloporphyrin-based dyes or phthalocyanine dyes; and the like. Among the above, Ru complexes are preferable, and N719 dye and black dye are particularly preferable since they have a wide absorption spectrum in a visible light range.

The N719 dye is a compound represented by ($RuL_2(NCS)_2 \cdot 2TBA$), and the black dye is a compound represented by ($RuL'_1(NCS)_3 \cdot 2TBA$). Here, L represents 4,4'-dicarboxy-2,2'-dipyrridine, L' represents 4,4'4''-tetra-carboxy-2,2',2''-ter-pyridine, and TBA represents tetrabutylammonium cation. The above sensitizers can be used solely or in combination of two or more.

The amount of the sensitizer supported in the photoelectric conversion layer 23 per unit area of the functional semiconductor layer $23\alpha$ is $1 \times 10^{-8}$ mol/cm$^2$ to $1 \times 10^{-7}$ mol/cm$^2$, and is preferably $3 \times 10^{-8}$ mol/cm$^2$ to $7 \times 10^{-8}$ mol/cm$^2$. When the amount of the sensitizer supported is within the above range, since the sensitizer is supported on the surfaces of the semiconductor particles as a monolayer, sufficient absorption efficiency can be obtained without the occurrence of energy loss, such as the reduction of an electrolyte in the electrolyte portion by excited electrons in the sensitizer.

[Substrate]

The translucent substrate 21 that configures the photoelectric conversion element 10 of the example is produced by forming the transparent conductive layer 21b on the translucent support 21a.

As the translucent support 21a, supports made of a variety of materials, such as glass and plastic, can be used, and, from the viewpoint of translucency, heat resistance, resistance to chemicals, and the like, for example, a plate or film-shaped cycloolefin-based polymer, a plate or film-shaped acryl urea-based polymer, a plate or film-shaped polyester, a plate or film-shaped polyethylene naphthalate, and the like can be preferably used as the plastic translucent support.

The surface resistance of the substrate 21 is preferably 100 $\Omega$/□ or less, and more preferably 15 $\Omega$/□ or less. The surface resistance was measured using a Loresta-GP MCP-T610 manufactured by Mitsubishi Chemical Analytech Co., Ltd. This device is based on JIS K 7194-1994. The unit is expressed by $\Omega$/sq. or $\Omega$/□, but is substantially $\Omega$ (sq. and □ are dimensionless).

In addition, in the present invention, the surface resistance refers to a numeric value obtained by dividing the electric gradient in parallel with a current flowing along the surface of a specimen by a current per unit width of the surface. This numeric value is defined in JIS K 6911-1995 to equal the surface resistance between two electrodes which are the sides of the 1 cm $\times$ 1 cm square plates facing each other.

[Transparent conductive layer]

The transparent conductive layer 21b formed on a surface of the translucent support 21a can be formed of, for example, an indium-tin complex oxide (ITO), fluorine-doped tin oxide (FTO) or the like.

[Method for forming the photoelectric conversion layer]

The photoelectric conversion layer 23 of the photoelectrode 20 can be manufactured by undergoing the following steps (1) to (5) in this order as illustrated in FIGS. 2A to 2D.

(1) A substrate-manufacturing step of forming the transparent conductive layer 21b on the support 21a so as to obtain the translucent substrate 21, and carrying out a surface treatment as necessary (refer to FIG. 2A)
(2) A paste-preparing step of adjusting the paste containing the semiconductor particles
(3) A coated film-forming step of applying the paste to the transparent conductive layer 21b in the substrate 21 and drying the paste on the transparent conductive layer 21b in the substrate 21 so as to obtain the coated film 23A (refer to FIG. 2B)
(4) A roll-pressing step of roll-pressing the coated film 23A formed on the substrate 21 so as to obtain the photoelectrode structure 20K having the functional semiconductor layer 23$\alpha$ (refer to FIG. 2C)
(5) A dye-supporting step of allowing the functional semiconductor layer 23$\alpha$ to support the sensitizer (refer to FIG. 2D)

[Substrate-manufacturing step]

The substrate 21 is obtained by forming the transparent conductive layer 21b on the support 21a using, for example, a sputtering method or the like.
The transparent conductive layer 21b is preferably formed while being heated from the viewpoint of the adhesiveness with respect to the support 21a or durability of the transparent conductive layer 21b.
The temperature of the heating treatment is generally, for example, 100°C to 150°C; however, in a case in which the support 21a that configures the substrate 21 is made of plastic, the temperature of the heating treatment is a temperature lower than the heatproof temperature of the plastic that configures the support 21a. Here, the "heatproof temperature" refers to the lower temperature of the softening point or melting point of the plastic.

[The surface treatment of the substrate]

The surface of the above substrate 21, that is, the surface of the transparent conductive layer 21b may be subjected to one or a combination of two or more of surface treatments, such as an ultrasonic cleaning treatment, an etching treatment, a UV-ozone treatment and the like. A dye-sensitized solar cell obtained using the substrate 21, which has undergone the surface treatment, exhibits excellent conversion efficiency.
This is considered to be because the surface treatment improves both the wettability when the paste is applied to the substrate 21 and the adhesiveness of the semiconductor particles to the substrate 21 after the pressing treatment, and it is confirmed that, for example, the contact angle of the surface of the substrate 21 before the surface treatment is larger than 90°, and the contact angle after the surface treatment is reduced to approximately 80° to 90°.
Other treatments in addition to the ultrasonic cleaning treatment, the etching treatment and the UV-ozone treatment, such as sputtering, can be appropriately used as the surface treatment of the substrate 21, and the surface treatment is not limited thereto.
The ultrasonic cleaning treatment refers to a treatment in which an ultrasonic cleaner and an ultrasonic cleaning agent are used, the substrate is immersed into a container provided with the cleaning agent, the container is put into the ultrasonic cleaner filled with water, and ultrasonic waves are generated for several minutes to 10 minutes, thereby cleaning and removing fine attachments on the surface of the substrate.
In the etching treatment, the substrate is set in a high-frequency sputtering apparatus "SVC-700 RFII" (manufactured by Sanyu Electron Co., Ltd.), a high vacuum condition (5 Pa) is set, and then a reverse sputtering (etching) treatment is carried out under the conditions of 20 W and 10 minutes. Specifically, a plasma is generated by applying a high-frequency alternating potential, and argon atoms charged with positive charges in the plasma are made to collide with the substrate to which negative charges have been applied, thereby removing attachments on the substrate.
The UV-ozone treatment can be carried out by, for example, feeding a treatment subject into an UV-ozone cleaning apparatus "OC-2506" (manufactured by Iwasaki Electronic Co., Ltd.), and radiating ultraviolet rays for approximately 5 minutes.

[Paste-preparing step]

The paste used in the manufacturing method of the present invention contains the semiconductor particles, and can arbitrarily contain a solvent, a binder and the like.
The method for manufacturing the paste containing the specific semiconductor particle group that configures the photoelectric conversion layer 23 is not particularly limited; however, for example, a basic method created by the present inventors, in which an alkoxide is hydrolyzed using a quaternary ammonium salt, can be preferably used. Specifically, the basic method can prepare the paste by obtaining paste by hydrolyzing an alkoxide for obtaining the small semiconductor particles using a quaternary ammonium salt, obtaining paste by hydrolyzing an alkoxide for obtaining the large semiconductor particles using a quaternary ammonium salt in the same manner, and mixing the paste.

The average particle diameter of the obtained semiconductor particles can be controlled by adjusting the amount of the quaternary ammonium salt added for the hydrolysis, and the semiconductor particles having a small average particle diameter can be obtained by increasing the amount of the quaternary ammonium salt added.

As the quaternary ammonium salt, for example, tetramethyl ammonium hydroxide (TMAH) can be used, but the methyl group is not limited, and can be exemplified by methyl groups having an alkyl group with one to four carbon atoms.

In addition, as the alkoxide for obtaining the large semiconductor particles, an alkoxide of the above metal that configures the semiconductor particles can be used.

Specifically, for example, in a case in which the semiconductor particles are titania particles, it is possible to use $Ti(OC_3H_5)_4$ as the alkoxide of the semiconductor particles and TMAH as the quaternary ammonium salt.

The content ratio of the specific semiconductor particle group to the paste is preferably 5 mass% to 85 mass%, more preferably 5 mass% to 30 mass%, and still more preferably 8 mass% to 20 mass%.

When the paste manufactured using the basic method is used, paste including water as the principal component of a solvent can be used, and it is possible to manufacture paste having a low environmental load.

[Coated film-forming step]

This step is a step of obtaining the coated film 23A by applying the paste to the transparent conductive layer 21b of the translucent substrate 21 and drying the paste on the transparent conductive layer 21b of the translucent substrate 21, and the method for applying the paste to the transparent conductive layer 21b of the translucent substrate 21 is not particularly limited, and the paste can be applied using a variety of well-known methods, for example, the doctor blade method or the spraying method.

In addition, the drying temperature can be, for example, room temperature.

A section coated with aqueous paste on the transparent conductive layer 21b functions as a working electrode, and the area of the working electrode section can be appropriately selected according to the use.

The area of the working electrode that can be manufactured using the manufacturing method of the present invention varies depending on the performance of a roll-pressing machine used in the roll-pressing step described below, but it is possible to manufacture the section having, for example, a size of approximately 20 cm × 20 cm or more.

[Roll-pressing step]

This step is a step of roll-pressing the coated film 23A so as to obtain the functional semiconductor layer 23α, and the roll-pressing treatment can sufficiently adhere the semiconductor particles to each other in the coated film 23A so as to obtain a high electron transport function.

Due to the roll-pressing treatment, roll-pressing traces extending in parallel (or substantially parallel; this shall apply below) with the roll-pressing treatment direction are formed on the surface of the functional semiconductor layer 23α. Since the generation of the roll-pressing traces can mitigate an external stress in a case in which the photoelectrode for a dye-sensitized solar cell is bent or a case in which a temporary external stress, such as an impact, is applied, it is possible to make the configuration more resistant to an external stress than the configuration including no roll-pressing trace.

The roll-pressing traces can be visually observed using a scanning electron microscope (SEM). Due to the presence of the roll-pressing traces, the surface roughness Ra significantly differs in a direction that is parallel with the roll-pressing treatment direction (a first direction) and a vertical direction that is orthogonal to the first direction (a second direction, hereinafter sometimes referred to simply as "vertical direction") on the surface of the functional semiconductor layer 23α, and the surface roughness Ra in the second direction becomes 1.2 times the surface roughness Ra in the first direction. This value is preferably 1.25 times or more from the viewpoint of the mitigation of a stress described above.

In addition, the surface roughness Ra can be measured using an atomic force microscope (AFM). Regarding the surface roughness Ra of the functional semiconductor layer 23α, the surface roughness Ra in the vertical direction to the roll-pressing treatment direction becomes larger than the surface roughness Ra in the parallel direction to the roll-pressing treatment direction. This mainly results from the mechanism of forming the roll-pressing traces. That is, during the roll pressing treatment, a rotating roll comes into contact with the substrate having a predetermined tension supplied, and therefore not only is the surface shape of the roll surface transferred, but the outer circumferential surface of the roll also relatively shifts with respect to the functional semiconductor layer slightly. As a result, it is considered that the surface shape of a portion of the roll, which comes into contact with the functional semiconductor layer, is transferred to the surface of the functional semiconductor layer throughout a predetermined range in the roll-pressing treatment direction.

In addition, the roll-pressing treatment is more advantageous than flat pressing (which is not the roll-pressing treatment, and refers to a method in which the coated film 23A is sandwiched and pressed between top and bottom flat plates) when a large area is pressed. In the flat pressing, since the pressing pressure per unit area decreases as the area to be pressed increases, and it is necessary to increase the pressure proportionally with the area when a large area is pressed, the size of the machine is also increased in accordance with the area to be pressed, which is not suitable industrially. However, in the roll pressing treatment, it is not necessary to increase the pressure applied to the roll even when the area to be pressed increases, and the pressure may be constant at all times, which is suitable industrially.

In addition, the roll-pressing treatment can produce a photoelectrode at a high speed and reduce the manufacturing costs, which contributes to the high-speed production of a dye-sensitized solar cell having the photoelectrode and the reduction of the manufacturing costs.

The roll-pressing treatment is preferably carried out in a range of 15°C to 35°C.

However, the temperature of the roll-pressing treatment is not limited thereto, and can be higher than the above in order to supply necessary properties to the functional semiconductor layer.

In addition, in a case in which a solvent is used in the paste for forming the photoelectric conversion layer, the temperature of the roll-pressing needs to be the boiling point of the solvent + 50°C or lower. This is because, in a case in which the roll-pressing is carried out at the above temperature or higher, the solvent being used is abruptly evaporated, and the surface is roughened.

In addition, in a case in which a solvent is not used in the paste for forming the photoelectric conversion, the temperature of the roll-pressing is preferably no higher than 200°C. This is because the roll-pressing at higher than 200°C causes not only the degradation of the performance of the semiconductor layer but also the easy occurrence of the deformation of the substrate, which results from the use of the plastic substrate, or the oxidation of the paste used in the roll-pressing treatment and the inhibition of the adhesion between the particles. In a case in which the softening point (temperature) or glass transition point of the substrate material is lower than 200°C, it is necessary to carry out the roll-pressing at a temperature lower than the above temperature.

In addition, the roll pressing treatment is carried out under a condition that the light transmittance at a wavelength of 400 nm to 800 nm of a laminate having the functional semiconductor layer $23\alpha$ formed on the translucent substrate 21 preferably becomes 105% to 170%, more preferably becomes 110% to 170%, and particularly preferably becomes 110% to 130% of the light transmittance before the roll-pressing treatment, and the roll-pressing treatment is preferably carried out at a pressure of, for example, 5 MPa or more, and preferably 30 MPa or more. In addition, when the roll-pressing is carried out at a pressure of 500 MPa or less, and preferably 200 MPa or less, it is possible to generate the roll-pressing traces at the same time while achieving the above light transmittance.

In a case in which the pressure of the roll-pressing treatment is too high, there are cases in which not only the support is deformed so as to adversely influence the performance of the dye-sensitized solar cell, but also the transparent conductive layer formed on the support is broken, which is not preferable.

In addition, the thickness of the functional semiconductor layer $23\alpha$ preferably becomes 95% to 30%, and more preferably becomes 90% to 50% of the thickness before the roll-pressing treatment through the roll-pressing treatment.

[UV-ozone treatment]

Before the subsequent dye-supporting step and after the roll-pressing step, the UV-ozone treatment can be carried out as necessary as the surface treatment of the roll-pressed functional semiconductor layer $23\alpha$. In any case in which the UV-ozone treatment is or is not carried out as the surface treatment of the translucent substrate 21, it is possible to carry out the UV-ozone treatment.

The UV-ozone treatment is considered to allow the cleaning of the surfaces of the semiconductor particles that configure the functional semiconductor layer $23\alpha$, and to increase hydrophilic groups of the semiconductor particles so as to make the sensitizer easily adsorbable, and, consequently, the obtained dye-sensitized solar cell can be provided with high conversion efficiency.

In a case in which a method in which TMAH used for the manufacturing of the titania particles remains as an unreacted substance in the functional semiconductor layer $23\alpha$, such as the basic method, is used in the paste-preparing step, it is possible to decompose the TMAH through the UV-ozone treatment so as to clean the surfaces of the semiconductor particles. The UV-ozone treatment can be carried out in the same manner as the UV-ozone treatment for the translucent substrate 21.

[Dye-supporting step]

The method for allowing the functional semiconductor layer $23\alpha$ of the photoelectrode structure 20K to support the sensitizer is not particularly limited, and examples thereof include an immersion method, in which the sensitizer is dissolved in a solvent, such as an alcohol solvent, a nitrile solvent, a nitromethane solvent, halogenated hydrocarbon, an ether solvent, dimethyl sulfoxide, an amide solvent, N-methylpyrrolidone, 1,3-dimethylimidazolidinone, 3-methyloxazolidinone, an ester solvent, a carbonate solvent, a ketone solvent, hydrocarbon or water; or a solvent mixture of two or more solvents, and the photoelectrode structure 20K having the functional semiconductor layer 23α formed therein is immersed in the solution, a spray coating method, a print coating method and the like.

The photoelectrode 20 obtained using the above manufacturing method is provided with the photoelectric conversion layer 23 on the translucent substrate 21, and the photoelectric conversion layer 23 contains the specific semiconductor particle group and the sensitizer.

The dye-sensitized solar cell obtained using the above manufacturing method can have high conversion efficiency even when a plastic support is used. This is assumed to be because, since the semiconductor particles are pressurized on the plastic support, the semiconductor particles are somewhat embedded into the transparent conductive layer, and a more dense junction can be obtained.

[Electrolyte portion]

In the dye-sensitized solar cell of the present invention, the electrolyte portion 12 interposed between the photoelectrode 20 and the counter electrode 16 may have any of a liquid form, a solid form, a concrete form and an ambient temperature molten salt state.

In addition, the thickness of the electrolyte portion 12, that is, the separation distance between the photoelectrode 20 and the counter electrode 16 is, for example, 1 μm to 100 μm.

In a case in which the electrolyte portion 12 has, for example, a solution form, the electrolyte portion 12 is preferably configured of an electrolyte, a solvent and additives.

The electrolyte may be a combination of a metal iodide, such as lithium iodide, sodium iodide, potassium iodide or cesium iodide, and iodine; a combination of an iodine salt of a quaternary ammonium compound, such as tetraalkyl ammonium iodide, pyridinium iodide or imidazolium iodide, and iodine, a combination of a bromine compound and bromine, instead of iodine and the iodine compound, a combination of a cobalt complex, or the like. In a case in which the electrolyte is an ionic liquid, it is not necessary to use a solvent in particular. The electrolyte may be a gel electrolyte, a polymer electrolyte or a solid electrolyte, and an organic charge transport substance may be used instead of the electrolyte.

In a case in which the electrolyte portion 12 has a solution form, examples of the solvent include nitrile-based solvents, such as acetonitrile, methoxyacetonitrile or propionitrile; carbonate-based solvents, such as ethylene carbonate; ether-based solvents, alcohol-based solvents and the like.

In a case in which the electrolyte portion 12 has a solution form, the concentration of the electrolyte in an electrolyte solution varies depending on the type of the electrolyte, and, for example, in a case in which the electrolyte is a combination of an iodine salt and iodine, the concentration is preferably 0.1 M to 5.0 M and more preferably 0.1 M to 1.0 M.

[Counter electrode]

The counter electrode 16 functions as the positive electrode of the photoelectric conversion element 10, and can be formed by supporting a substance having a function of reducing the electrolyte, for example, a metal, such as platinum, a conductive polymer or carbon, on a substrate formed of a conductive metal oxide, such as ITO or FTO, or a metal. Generally, the counter electrode 16 may be configured by providing a conductive film made of the above metal, carbon or conductive polymer on a conductive support or a support having the same conductive layer as the conductive support, but the counter electrode does not necessarily have the support as long as sufficient strength and sealing properties can be obtained.

[Method for manufacturing the photoelectric conversion element]

For example, in a case in which the electrolyte portion 12 has a liquid form, the above photoelectric conversion element 10 that configures the dye-sensitized solar cell can be obtained by disposing the photoelectrode 20 and the counter electrode 16 so as to face each other through an appropriate spacer, and feeding the electrolyte portion 12 between the photoelectrode 20 and the counter electrode 16.

The above photoelectric conversion element 10 can be manufactured into a variety of shapes depending on the use, and the shape is not particularly limited.

Photoelectric conversion is carried out in the dye-sensitized solar cell in the following manner.

First, incident solar light that has transmitted through the translucent substrate 21 of the photoelectrode 20 is absorbed in the sensitizer in the bottom state, which is supported on the surfaces of the semiconductor particles in the photoelectric conversion layer 23, so as to excite the sensitizer, thereby generating electrons. The electrons are injected into the semiconductor particles, and the electrons injected into the semiconductor particles diffuse in the photoelectric conversion layer 23, pass through the transparent conductive layer 21b and the connection wire 17, and are led to the counter electrode 16. On the other hand, the sensitizer that has lost the electrons receives electrons from the electrolyte portion 12 so as to return to the bottom state. In addition, the electrolyte portion 12 that has provided the electrons so as to be oxidized receives electrons from the counter electrode 16 so as to be reduced and returns to the base state. Due to the above series of steps, an electromotive force is generated between the translucent substrate 21, which is electrically connected to the photoelectric conversion layer 23, and the counter electrode 16.

According to the dye-sensitized solar cell 1 made up of the above photoelectric conversion element 10, in a case in which two or more kinds of specific semiconductor particles having different average particle diameters are used in the photoelectric conversion layer 23 of the photoelectrode for a dye-sensitized solar cell 20, it is possible to achieve high light absorption efficiency through a so-called optical confinement effect in the sensitizer included in the photoelectric conversion layer 23, to form the photoelectric conversion layer 23 on the substrate 21 using a high adhesiveness by using paste for the photoelectric conversion layer 23 and a specific method even in a case in which the support 21a of the substrate 21 is made of any material, that is, for example, a case in which a plastic substrate, with which it was difficult to obtain high light absorption efficiency in the related art, is used, and, consequently, to maintain a high level of conversion efficiency even in a case in which a plastic substrate is used, and the amount of incident light is changed.

<Second embodiment>

A second embodiment of the present invention will be described. The difference between a dye-sensitized solar cell 101 of the present embodiment and the dye-sensitized solar cell of the first embodiment is that the photoelectric conversion layer has a plurality of layers. In the following description, duplicate configuration that has been already described will be given the same reference signs, and will not be described again.

FIG. 3 is an explanatory cross-sectional view illustrating an example of the configuration of a cell 110 that configures a dye-sensitized solar cell 101 of the embodiment. As illustrated in FIG. 3, in a photoelectrode 120 of the cell 110, a photoelectric conversion layer 123 provided on the substrate 21 has a first layer 123A and a second layer 123B containing the specific semiconductor particle group and the sensitizer respectively.

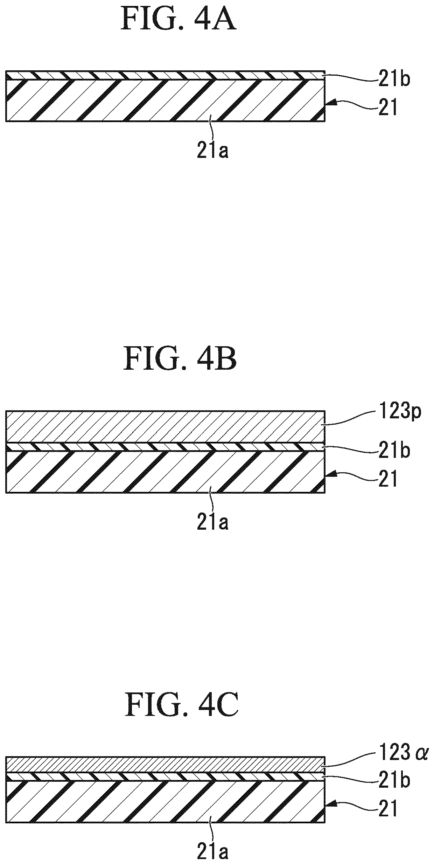

The first layer 123A is formed by increasing the adhesiveness to the substrate 21 using the roll-pressing treatment, and, specifically, the sensitizer, not shown, is supported in a functional semiconductor layer 123$\alpha$ which is formed by roll-pressing a coated film 123p (refer to FIG. 4B) of the paste containing the specific semiconductor particle group.

The second layer 123B is formed on the first layer 123A, and improves the battery characteristics of the dye-sensitized solar cell. The method for forming the second layer 123B is not particularly limited, and may be formed using the roll-pressing treatment in the same manner as for the first layer 123A, or may be formed using another method, for example, a flat pressing method, sintering of the coated film, or the like. In addition, the kind or content ratio of the specific semiconductor particle group in the second layer 123B may be the same as or different from the kind or content ratio of the specific semiconductor particle group in the first layer 123A. In the former case, the battery performance can be improved by increasing the film thickness of the photoelectric conversion layer, and, in the latter case, the battery performance can be improved by scattering light.

In a case in which the second layer 123B is made to exhibit a light-scattering function, the semiconductor particles having an average particle diameter of 50 nm or more are preferably included as a main component. However, when the average particle diameter exceeds 1 $\mu$m, the particles become prone to dropping, and therefore the average particle diameter of the particles used as the principal material is preferably set in a range of 50 nm to 1 $\mu$m. Even in this case, a small amount of particles having an average particle diameter of 50 nm or less, for example, particles having an average particle diameter of 20 nm may be mixed in order to ensure adhesiveness as a layer.

The thicknesses of the first layer 123A and the second layer 123B can be appropriately set, and, for example, it is possible to set the thickness of the first layer 123A to 1 $\mu$m to 20 $\mu$m, and to set the thickness of the second layer 123B to $\mu$m to 15 $\mu$m. In addition, a layer containing the specific semiconductor particle group may be further formed on the second layer 123B.

The photoelectrode 120 of the embodiment can be manufactured by undergoing the following steps (1) to (6) in this order as illustrated in FIGS. 4A to 4F.

(1) A substrate-manufacturing step of forming the conductive layer 21b on the support 21a so as to obtain the substrate 21, and carrying out a surface treatment as necessary (refer to FIG. 4A)
(2) A paste-preparing step of adjusting the paste containing the semiconductor particles
(3) A coated film-forming step of coating and drying the paste on the conductive layer 21b in the substrate 21 so as to obtain the coated film 123p (refer to FIG. 4B)

(4) A roll-pressing step of roll-pressing the coated film 123p formed on the substrate 21 so as to obtain the functional semiconductor layer 123α (refer to FIG. 4C)

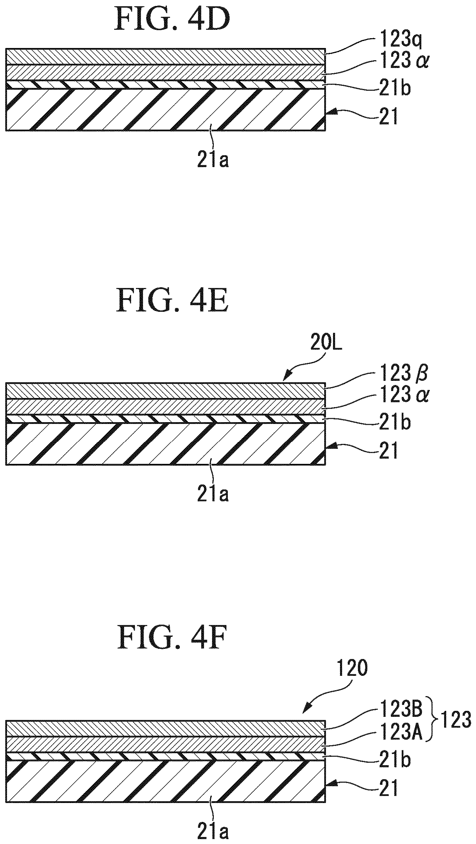

(5) A second layer-forming step of forming a functional semiconductor layer 123β, which becomes the second layer, on the functional semiconductor layer 123α so as to obtain a photoelectrode structure 20L (refer to FIGS. 4D and 4E)

(6) A dye-supporting step of allowing the functional semiconductor layer 123α and the functional semiconductor layer 123β to support the sensitizer so as to form the first layer 123A and the second layer 123B, thereby obtaining the photoelectrode 120

(refer to FIG. 4F)

Among the above steps, the respective steps except for the second layer-forming step are substantially the same as those in the first embodiment, and therefore only the second layer-forming step will be described below.

[Second layer-forming step]

As illustrated in FIG. 4D, one or more layers of a coated film 123q of the paste containing the specific semiconductor particle group are formed on the functional semiconductor layer 123α so as to form the functional semiconductor layer 123β. One to three layers of the coated film 123q can be laminated. In addition, when a predetermined treatment, such as sintering, flat pressing or roll-pressing, is carried out after the formation of the coated film 123q, as illustrated in FIG. 4E, the functional semiconductor layer 123β, which becomes the second layer 123B, is completed.

The roll-pressing treatment carried out when forming the functional semiconductor layer 123β can be carried out under the same condition as for the roll-pressing treatment when forming the functional semiconductor layer 23α in the first embodiment. In a case in which the pressure of the roll-pressing treatment is too high, there are cases in which not only the translucent support is deformed so as to adversely influence the performance of the dye-sensitized solar cell, particularly in a case in which a plastic translucent support is used, but also the transparent conductive layer formed on the translucent support is broken, which is not preferable. The thickness of the functional semiconductor layer 123β preferably becomes 80% to 30% of the thickness of the coated film 123q that has not yet been roll-pressed through the roll-pressing treatment.

In addition, the same as in the first embodiment, before the subsequent dye-supporting step and after the formation of the functional semiconductor layer 123β, the UV-ozone treatment can be carried out as necessary as the surface treatment of the functional semiconductor layer 123β. The UV-ozone treatment may be carried out at the same time on the functional semiconductor layer 123α and the functional semiconductor layer 123β.

According to the photoelectrode 120 of the embodiment and the dye-sensitized solar cell 101 having the photoelectrode, similarly to the first embodiment, it is possible to produce the photoelectrodes for a dye-sensitized solar cell at a high speed using the roll-pressing treatment and to reduce the manufacturing costs.

In addition, when the photoelectric conversion layer 123 includes the roll-pressed first layer 123A and the second layer 123B formed on the first layer 123A, it is possible to improve the battery performance while increasing the adhesiveness between the translucent substrate 21 and the photoelectric conversion layer 123.

<Third embodiment>

A third embodiment of the present invention will be described. The difference between a dye-sensitized solar cell 2101 of the present embodiment and the dye-sensitized solar cells of the above respective embodiments is that the substrate of the photoelectrode is made of metal.

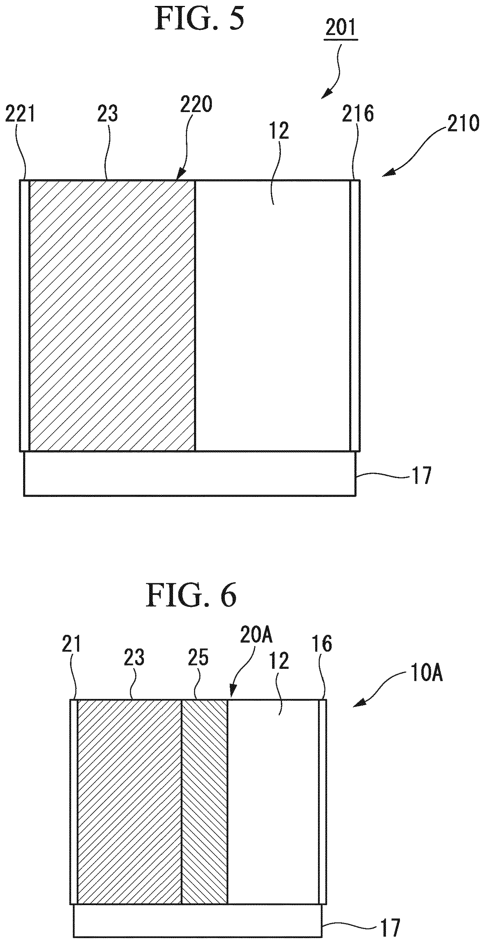

FIG. 5 is an explanatory cross-sectional view illustrating an example of the configuration of a cell 210 that configures a dye-sensitized solar cell 201 of the embodiment. As illustrated in FIG. 5, a photoelectrode 220 of the cell 210 is configured by providing the photoelectric conversion layer 23 on a metal substrate 221. The remaining parts are substantially the same as in the first embodiment, and therefore only the metal substrate 221 and relevant things will be described below in detail.

As a metal material of the metal substrate 221, a metal or an alloy having a specific resistance at room temperature of $1 \times 10^{-4}$ cm·Ω or less is preferably used. An alloy of Ti, Ni, Fe, Cu, Al, stainless steel (for example, stainless steel with an abbreviation of SUS in JIS) or the like is more preferably used. Ti or SUS is particularly preferably used. In the embodiment, since the metal substrate is used, it is not necessary to provide the conductive layer described in the first embodiment and the second embodiment.

In addition, since the photoelectrode 220 is not translucent, it is necessary to enter light from the counter electrode side in the dye-sensitized solar cell 201. Therefore, a transparent support is used as a material that configures a counter electrode 216. A PEN film or a PET film is preferably used as the material. In addition, it is preferable to decrease the surface resistance by using a transparent conductive metal oxide, such as ITO or FTO, on the transparent support, and, furthermore, it is preferable to use Pt, a conductive polymer, carbon or the like as a catalyst on the surface of the transparent conductive metal oxide on the electrolyte portion side.

Meanwhile, the light transmittance of the functional semiconductor layer cannot be measured on the metal substrate 21. Therefore, in a case in which the transmittance of the functional semiconductor layer is measured in the embodiment, the functional semiconductor layer is formed on a transparent film, such as PET, under the same conditions, and the transmittance is measured.

Next, the differences of a step of manufacturing the dye-sensitized solar cell 201 from those of the above respective embodiments will be described.

When the surface roughness Ra of the functional semiconductor layer is 50 nm or less in the roll-pressing step, the adhesiveness with the metal substrate 221 increases, which is preferable. In addition, in a case in which a solvent is not used in the paste for forming the photoelectric conversion layer, the temperature of the roll-pressing treatment is preferably no higher than 550°C. This is because the roll-pressing at higher than 550°C causes not only the degradation of the performance of the functional semiconductor layer but also the generation of a metal oxide in the metal substrate 221, or the inhibition of the adhesion between the semiconductor particles. In addition, since the crystal system of the semiconductor particles changes due to heat, the battery performance degrades.

Even in the photoelectrode 220 of the embodiment and the dye-sensitized solar cell 201 having the photoelectrode, similarly to the first and second embodiments, it is possible to manufacture a dye-sensitized solar cell which can be produced at a high speed using the roll-pressing treatment and a reduced manufacturing cost.

In addition, with no regard to the material of the metal substrate 221, that is, for example, even in a case in which the metal substrate, with which it was difficult to obtain high light absorption efficiency in the related art, is used, it is possible to form the photoelectric conversion layer 23 on the metal substrate 221 with a high adhesiveness, and to maintain a high level of conversion efficiency.

Even in the embodiment, the photoelectric conversion layer can be configured to have the second layer as in the second embodiment. At this time, the thickness of the first layer may be, for example, within 1 $\mu$m to 40 $\mu$m, and the thickness of the second layer may be, for example, 1 $\mu$m to 15 $\mu$m. In the embodiment, the combined thickness of the first layer and the second layer is preferably 60 $\mu$m or less.

[Modified example]

In the photoelectrodes and the dye-sensitized solar cells of the respective embodiments of the present invention, a variety of modifications can be added.

For example, a light-scattering layer 25 made only of the large semiconductor particles may be formed on the surface of the photoelectric conversion layer 23 as illustrated in FIG. 6. The light-scattering layer 25 of the photoelectric conversion element 10A can also be made of, for example, a coated film of paste which contains water as the solvent, does not contain a binder and an organic solvent, and contains the large semiconductor particles. The thickness of the light-scattering layer 25 can be, for example, 1 $\mu$m to 15 $\mu$m.

According to the photoelectric conversion element 10A including the photoelectrode for a dye-sensitized solar cell 20A having the light-scattering layer 25 formed therein, it is possible to obtain an extremely high optical confinement effect, and, consequently, to configure a dye-sensitized solar cell having extremely high conversion efficiency.

In addition, the photoelectric conversion layer may be formed of a sensitizer-supported pressurized semiconductor layer which is obtained by allowing a coated film of paste containing the specific semiconductor particle group to support the sensitizer, but no binder and no organic solvent, and then roll-pressing the coated film. However, since the sensitizer is detached during the roll-pressing treatment in the manufacturing step, compared to a case in which a coated film of paste is roll-pressed, and then the sensitizer is supported, the performance of the obtained dye-sensitized solar cell slightly degrades.

[Examples]

Hereinafter, specific examples of the present invention will be described, but the present invention is not limited thereto.

[Example 1]

(Preparation of titania semiconductor particle suspension)

Titanium isopropoxide (56.8 g) was added dropwise to 200 mL of ion-exchange water under stirring, and the solution was further stirred for 1 hour after the completion of the dropwise addition so as to complete hydrolysis, thereby obtaining a target sediment of titanium hydroxide. The sediment was filtered using filter paper, and sufficiently washed using ion-exchange water.

This sediment was added to ion-exchange water in which 5.8 g of tetramethylammonium hydroxide (TMAH) had been dissolved, and ion-exchange water was further added, thereby adjusting the total amount of a specimen to 160 g.

After the specimen was heated to reflux at 140°C for 4 hours, microcrystals were removed using a glass filter, thereby obtaining a half-transparent white colloid solution.

The obtained colloid solution was moved to a closed autoclave vessel, was hydrothermally synthesized at 260°C for 8 hours, after the hydrothermal synthesis, the solvent of the colloid solution was substituted into ethanol using an evaporator, and an ultrasonic dispersion treatment was carried out, thereby obtaining an ethanol suspension [A] including anatase crystal-type titania particles [A] having an average particle diameter of 20 nm (the above operation is called "the preparation operation of a semiconductor particle suspension").

Trimethylamine generated due to the decomposition of TMAH was almost fully removed when the solvent of the colloid solution was substituted into ethanol.

In the preparation operation of a semiconductor particle suspension, an ethanol suspension [B] including anatase crystal-type titania particles [B] having an average particle diameter of 100 nm was obtained in the same manner except that the amount of TMAH added was 1.5 g.

For the titania particles included in the ethanol suspensions [A] and [B], the ethanol suspension was applied to and dried on a glass slide using the doctor blade method, then, an XRD pattern was measured, a half width was obtained from the obtained XRD pattern, the average particle diameter was obtained using Scherrer's equation ($D = K \times \lambda/\beta\cos\theta$), and the crystal type of the titania particles was confirmed. In the equation, D represents the length of a crystallite, $\beta$ represents the half width, $\theta$ represents the diffraction angle, $K = 0.94$, and $\lambda = 1.5418$.

In the titania particles [A] and the titania particles [B], the crystal types were almost all anatase crystal types, and the presence of the rutile crystal-type was not confirmed.

Since Scherrer's equation produces a large error in a case in which the average particle diameter exceeds 50 nm, in a case in which the average particle diameter exceeded 50 nm, the following method was used. That is, the ethanol suspension was applied to and dried on a glass slide using the doctor blade method, then, photographed using a SEM, and an arithmetic average of the particle radiuses of particles observed in a photograph was obtained, and used as the average particle diameter.

(Preparation of the aqueous paste for forming the photoelectric conversion layer)

For the two ethanol suspensions [A] and [B], first, the mass (W) of a crucible was weighed, then, the ethanol suspension was fed into the crucible, the total mass (W1) of the crucible and the ethanol suspension was weighed, the ethanol suspension in the crucible was put into an electric furnace, held at 150°C for 2 hours so as to fully remove the solvent of the ethanol suspension, subsequently, the mass (W2) was weighed again, and the concentration of the titanium particles in each of the suspensions was obtained using an equation [the concentration (wt%) of the titania particles = (W2 - W) / (W1 - W) $\times$ 100].

In addition, based on the respective concentrations, the titania particles [A] and the titania particles [B] were mixed so that the weight ratio became 7:3, the solvent of the liquid mixture was almost all substituted into water using an evaporator again, and condensed, thereby, finally, obtaining paste for forming the photoelectric conversion layer [1] in which the concentration of the titania particles was 10 wt% and water was used as a medium.

(Manufacturing of the functional semiconductor layer)

After the aqueous paste for forming the photoelectric conversion layer [1] was applied to a working electrode section with a size of 0.5 cm x 0.5 cm on a translucent substrate made of an ITO/PEN (polyethylene naphthalate) substrate (manufactured by Tobi Co., Ltd.) having a surface resistance of 13 $\Omega/\square$ using the doctor blade method, then, dried at room temperature so as to obtain a coated film, and the coated film was roll-pressed using a roll-pressing machine including a metal roll. The roll-pressing treatment was carried out using the roll-pressing machine by rotating a roll press having a diameter of 25 cm at a predetermined pressing pressure and 1 rpm. The pressure of the roll press was confirmed by adjusting the clearance and using a pressure-sensitive film (PRESCALE, manufactured by Fujifilm Corporation). Meanwhile, the pressure-sensitive film was disposed on the surface of the substrate, on which the titania-coated film was not formed. The pressing pressure was set by adjusting the roll clearance while checking the actual pressing weight using the pressure-sensitive film. The paste was roll-pressed from both surfaces at a pressure of 100 MPa, thereby obtaining a photoelectrode structure having the functional semiconductor layer formed on the translucent substrate.

The roll-pressing treatment increased the light transmittance of the functional semiconductor layer at a wavelength of 400 nm to 800 nm to 110% of the light transmittance before the roll-pressing treatment, and reduced the thickness to 70%, which was approximately 6 $\mu$m. The effective cell area was corrected to four significant figures using a digital microscope and calibration scales. The measurements of the transmittance of the photoelectrode structure at a wavelength of 200 nm to 900 nm were carried out on the sample before and after the roll-pressing treatment. Meanwhile, the transmittance was measured using a U-4000 (manufactured by Hitachi High-Technologies Corporation). In addition, the film thickness was measured using a stylus profilosmeter DEKTAK (manufactured by ULVAC Technologies, Inc.).

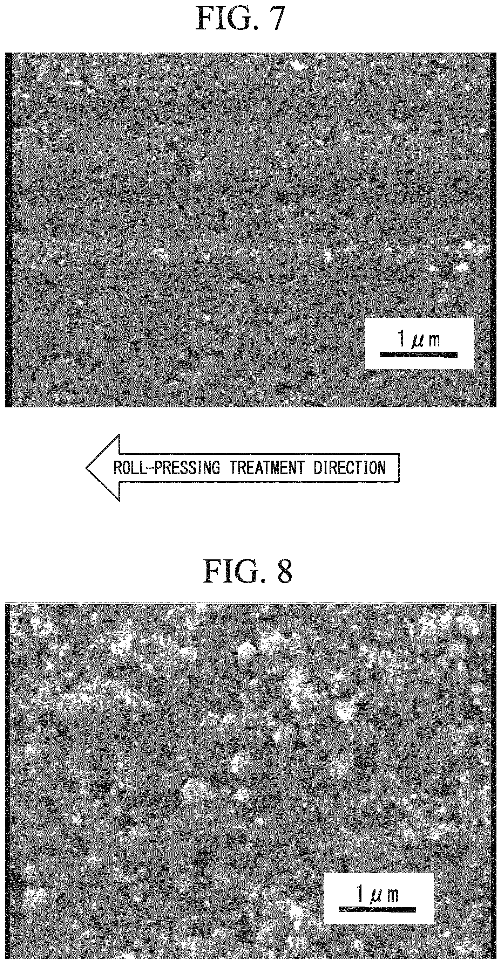

As a result of observing the 1000-time and 20000-time magnified SEM photographs of the coated film formed on the substrate after the roll-pressing treatment, as illustrated in FIG. 7, roll-pressing traces extending in parallel with the roll-pressing treatment direction were confirmed.

Furthermore, the film thicknesses of the functional semiconductor layer were measured before and after the roll-pressing treatment, and the surface roughness Ra of the functional semiconductor layer was measured using an atomic force microscope (AFM). The measurement was carried out in the following order.

First, on the surface of the functional semiconductor layer, a square section having a 10 $\mu$m-long side was measured using an AFM. At this time, the functional semiconductor layer was set so that the side of the square section became in parallel or substantially parallel with the roll-pressing treatment direction.

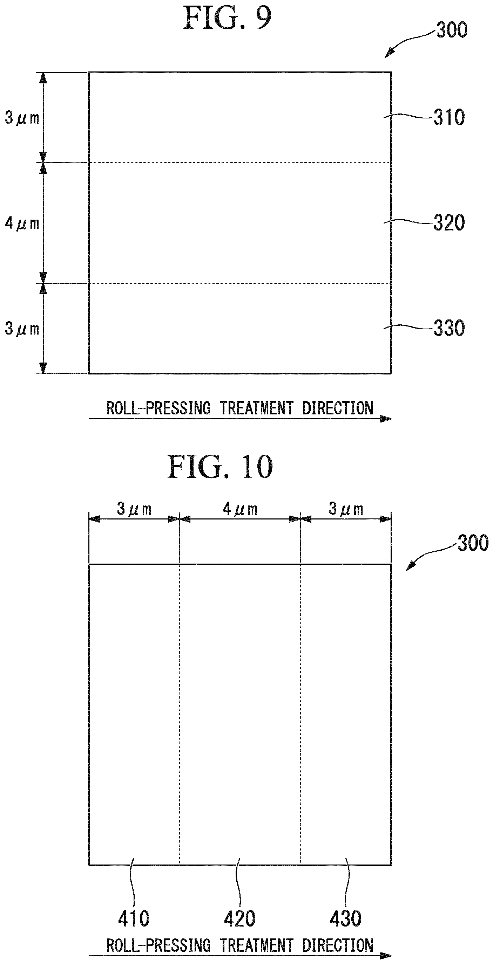

The square section 300 was divided into 3 $\mu$m-, 4 $\mu$m- and 3 $\mu$m-wide band-like sections extending in the roll-pressing treatment direction 310, 320 and 330 respectively as illustrated in FIG. 9, and the surface roughness Ra was computed using an AFM at each of the band-like sections 310, 320 and 330. A value obtained by dividing the sum of the obtained values of the surface roughness Ra by 3 was used as the surface roughness Ra in a first direction.

Next, the square section 300 was divided into 3 $\mu$m-, 4 $\mu$m- and 3 $\mu$m-wide band-like sections extending in a direction that is orthogonal to the roll-pressing treatment direction 410, 420 and 430 respectively as illustrated in FIG. 10, and the surface roughness Ra was computed using an AFM at each of the band-like sections 410, 420 and 430. A value obtained by dividing the sum of the obtained values of the surface roughness Ra by 3 was used as the surface roughness Ra in a second direction.

In addition, the surface roughness Ra in the second direction was divided by the surface roughness Ra in the first direction, thereby computing a surface roughness ratio. As a result, the surface roughness rate was 35.0 nm/19.3 nm = 1.81, and the anisotropy in the surface roughness Ra between in the first direction and in the second direction was confirmed.

The definition of the surface roughness Ra in the present invention was based on Img. Ra described in ASME B46.1.

(Supporting of the sensitizer and manufacturing of the photoelectrode)

Meanwhile, cis-bis(isothiocyanate)-bis(2,2'-dipyridyl-4,4'-dicarbonate)-ruthenium (II) bis-tetrabutylammonium was used as the sensitizer, and dissolved in ethanol at a concentration of 0.2 mM so as to obtain a dye solution, and the photoelectrode structure having the functional semiconductor layer formed therein was immersed in the dye solution for 24 hours, thereby obtaining a photoelectrode [1] having the sensitizer supported in the functional semiconductor layer.

As a result of observing the photoelectrode [1] using a SEM in the same manner as above, the same roll-pressing traces as confirmed in the SEM observation after the roll-pressing treatment were observed.

The surface roughness Ra of the photoelectric conversion layer is substantially the same as the surface roughness Ra of the functional semiconductor layer which does not yet support the sensitizer.

(Manufacturing of the dye-sensitized solar cell)

An acetonitrile solution having iodine, lithium iodide, 1,2-dimethyl-3-propyl imidazole lithium iodide and t-butylpyridine dissolved therein was used as the electrolyte solution. Iodine, lithium iodide, 1,2-dimethyl-3-propyl imidazole lithium iodide and t-butylpyridine were dissolved in acetonitrile in a nitrogen atmosphere so as to be 0.05 M, 0.1 M, 0.6 M and 0.5 M, respectively.

An electrode having platinum evaporated onto a 100 $\mu$m-thick Ti plate was used as the counter electrode.

A 50 $\mu$m-thick insulating spacer and the counter electrode were combined in this order to the photoelectrode [1], and the electrolyte solution was injected between the photoelectrode [1] and the counter electrode using a microsyringe, thereby manufacturing a dye-sensitized solar cell [1].

(Evaluation of the performance of the dye-sensitized solar cell)

In the dye-sensitized solar cell [1], I-V characteristics were measured using a "2400 SourceMeter" (manufactured by Keithley instruments Inc.) while radiating AM 1.5 pseudo solar light of 100 mW/cm$^2$ using a "solar simulator" (manufactured by Peccell Technologies, Inc.), thereby obtaining the values of short-circuit current, open voltage and form factor ff, and computing the conversion efficiency using the values and the following equation (1).

$$\text{Equation (1); conversion efficiency (\%)} = [\text{short-circuit current (mA/cm}^2) \times$$

$$\text{open voltage value (V)} \times \{\text{form factor ff / incident light (100 mW/cm}^2)\}] \times 100$$

[Example 2]

A dye-sensitized solar cell [2] was obtained in the same manner as in Example 1 except that paste containing only the titania particles [A] was used, and the values of the short-circuit current, open voltage, form factor ff and conversion efficiency of the dye-sensitized solar cell [2] were obtained in the same manner as in Example 1.

At this time, the surface of the obtained functional semiconductor layer was observed using a SEM, and roll-pressing traces extending in parallel with the roll-pressing treatment direction were confirmed.

In addition, the surface roughness Ra was measured in the same order as in Example 1, and the transmittance of the functional semiconductor with respect to the wavelength and the film thicknesses before and after the pressing treatment were measured.

As a result of measuring the surface roughness Ra, the surface roughness ratio was 34.1 nm/17.5 nm = 1.95, and the anisotropy in the surface roughness Ra between in the second direction and in the first direction was confirmed.

[Example 3]

A dye-sensitized solar cell [3] was obtained in the same manner as in Example 1 except that paste having the titania particles [A] and the titania particles [B] mixed at a weight ratio of 6:4 was used, and the values of the short-circuit current, open voltage, form factor ff and conversion efficiency of the dye-sensitized solar cell [3] were obtained in the same manner as in Example 1.

At this time, the surface of the obtained functional semiconductor layer was observed using a SEM, and roll-pressing traces extending in parallel with the roll-pressing treatment direction were confirmed.

In addition, the surface roughness Ra was measured in the same order as in Example 1, and the transmittance of the functional semiconductor with respect to the wavelength and the film thicknesses before and after the pressing treatment were measured.

As a result of measuring the surface roughness Ra, the surface roughness ratio was 13.7 nm/9.0 nm = 1.52, and the anisotropy in the surface roughness Ra between in the second direction and in the first direction was confirmed.

[Example 4]

A dye-sensitized solar cell [4] was obtained in the same manner as in Example 1 except that ITO/PET was used instead of the ITO/PEN substrate was used, and the values of the short-circuit current, open voltage, form factor ff and conversion efficiency of the dye-sensitized solar cell [4] were obtained in the same manner as in Example 1.

At this time, the surface of the obtained functional semiconductor layer was observed using a SEM, and roll-pressing traces extending in parallel with the roll-pressing treatment direction were confirmed.

In addition, the surface roughness Ra was measured in the same order as in Example 1, and the transmittance of the functional semiconductor with respect to the wavelength and the film thicknesses before and after the pressing treatment were measured.

As a result of measuring the surface roughness Ra, the surface roughness ratio was 23.9 nm/18.8 nm = 1.27, and the anisotropy in the surface roughness Ra between in the second direction and in the first direction was confirmed.

[Example 5]

A dye-sensitized solar cell [5] was obtained in the same manner as in Example 1 except that the working electrode section was 0.5 cm × 4.5 cm, and the values of the short-circuit current, open voltage, form factor ff and conversion efficiency of the dye-sensitized solar cell [5] were obtained in the same manner as in Example 1.

At this time, the surface of the obtained functional semiconductor layer was observed using a SEM, and roll-pressing traces extending in parallel with the roll-pressing treatment direction were confirmed.

In addition, the surface roughness Ra was measured in the same order as in Example 1, and the transmittance of the functional semiconductor with respect to the wavelength and the film thicknesses before and after the pressing treatment were measured.

As a result of measuring the surface roughness Ra, the surface roughness ratio was 25.5 nm/16.6 nm = 1.54, and the anisotropy in the surface roughness Ra between in the second direction and in the first direction was confirmed.

[Example 6]

A dye-sensitized solar cell [6] was obtained in the same manner as in Example 1 except that commercial paste "PECC-K01" (manufactured by Peccell Technologies, Inc.) was used as the paste, and the values of the short-circuit current, open voltage, form factor ff and conversion efficiency of the dye-sensitized solar cell [6] were obtained in the same manner as in Example 1.

At this time, the surface of the obtained functional semiconductor layer was observed using a SEM, and roll-pressing traces extending in parallel with the roll-pressing treatment direction were confirmed.

In addition, the surface roughness Ra was measured in the same order as in Example 1, and the transmittance of the functional semiconductor with respect to the wavelength and the film thicknesses before and after the pressing treatment were measured.

As a result of measuring the surface roughness Ra, the surface roughness ratio was 30.0 nm/16.4 nm = 1.83, and the anisotropy in the surface roughness Ra between in the second direction and in the first direction was confirmed.

The data of Examples 1 to 6 are described in Table 1.

[Table 1]

| | Base material | Paste | | Area | Pressing method | Pressing pressure |
|---|---|---|---|---|---|---|
| | | Titania A | Titania B | | | |
| Example 1 | PEN/ITO | 70 wt% | 30 wt% | 0.5 cm × 0.5 cm | Roll-pressing | 100 MPa |
| Example 2 | PEN/ITO | 100 wt% | - | 0.5 cm × 0.5 cm | Roll-pressing | 100 MPa |
| Example 3 | PEN/ITO | 60 wt% | 40 wt% | 0.5 cm × 0.5 cm | Roll-pressing | 100 MPa |
| Example 4 | PEN/ITO | 70 wt% | 30 wt% | 0.5 cm × 0.5 cm | Roll-pressing | 100 MPa |
| Example 5 | PEN/ITO | 70 wt% | 30 wt% | 0.5 cm × 4.5 cm | Roll-pressing | 100 MPa |
| Example 6 | PEN/ITO | PECC-K01 | | 0.5 cm × 0.5 cm | Roll-pressing | 100 MPa |

| | Short-circuit current mA/cm² | Open voltage V | Form factor (-) | Conversion efficiency % | Presence or absence of pressing traces | Surface roughness Ra in first direction nm | Surface roughness Ra in second direction nm | Surface roughness ratio | Film thickness | | Transmittance % | |
|---|---|---|---|---|---|---|---|---|---|---|---|---|
| | | | | | | | | | Before pressing (μm) | After pressing (μm) | 500 nm | 700 nm |
| Example 1 | 11.9 | 0.74 | 0.73 | 6.4 | Presence | 19.3 | 35.0 | 1.81 | 7.6 | 6.3 | 38.5 | 48.0 |
| Example 2 | 9.7 | 0.76 | 0.71 | 5.2 | Presence | 17.5 | 34.1 | 1.95 | 7.0 | 5.6 | 67.9 | 81.5 |
| Example 3 | 11.2 | 0.80 | 0.68 | 6.0 | Presence | 9.0 | 13.7 | 1.52 | 7.0 | 5.8 | 37.1 | 49.2 |
| Example 4 | 11.8 | 0.77 | 0.70 | 6.4 | Presence | 18.8 | 23.9 | 1.27 | 7.6 | 5.9 | 39.3 | 45.4 |
| Example 5 | 14.1 | 0.69 | 0.66 | 6.4 | Presence | 16.6 | 25.5 | 1.54 | 7.5 | 6.2 | 38.8 | 48.3 |
| Example 6 | 8.6 | 0.76 | 0.70 | 4.6 | Presence | 16.4 | 30.0 | 1.83 | 7.4 | 6.0 | 49.2 | 46.5 |

[Comparative Example A-1]

A Mini Test Press-10 (manufactured by Toyo Seiki Seisaku-sho, Ltd.) was used in a flat pressing treatment which substituted the roll-pressing treatment. A 5 mm-thick CONEX felt (manufactured by Du Pont Kabushiki Kaisha), a pressure-sensitive film ("PRESCALE", manufactured by Fujifilm Corporation), a translucent substrate, a fluorine mold release film and a 5 mm-thick CONEX felt (manufactured by Du Pont Kabushiki Kaisha) were sequentially laminated, and a laminate having a layer configuration of "CONEX felt"/"pressure-sensitive film"/"fluorine mold release film"/titania-coated ITO-PEN substrate/"CONEX felt" from the top was obtained. The laminate was pressed for 60 seconds while checking the actual pressing weight using the pressure-sensitive film. At this time, the weight was a pressure of 100 MPa.

A dye-sensitized solar cell [A-1] for comparison was obtained in the same manner as in Example 1 except that the flat pressing treatment was carried out instead of the roll-pressing treatment, and the values of the short-circuit current, open voltage, form factor ff and conversion efficiency of the dye-sensitized solar cell [A-1] for comparison were obtained in the same manner as in Example 1. At this time, as a result of observing the surface of the obtained functional semiconductor layer using a SEM, as in the enlarged photograph illustrated in FIG. 8, traces extending in a specific direction, such as the roll-pressing traces, were not observed. In addition, the transmittance of the functional semiconductor with respect to the wavelength and the film thicknesses before and after the pressing treatment were measured.

[Comparative Example A-2]

A Mini Test Press-10 (manufactured by Toyo Seiki Seisaku-sho, Ltd.) was used in a flat pressing treatment which substituted the roll-pressing treatment. A 5 mm-thick CONEX felt (manufactured by Du Pont Kabushiki Kaisha), a pressure-sensitive film ("PRESCALE", manufactured by Fujifilm Corporation), a translucent substrate, a fluorine mold release film and a 5 mm-thick CONEX felt (manufactured by Du Pont Kabushiki Kaisha) were sequentially laminated, and a laminate having a layer configuration of "CONEX felt"/"pressure-sensitive film"/"fluorine mold release film"/titania-coated ITO-PEN substrate/"CONEX felt" from the top was obtained. The laminate was pressed for 60 seconds while checking the actual pressing weight using the pressure-sensitive film. At this time, the weight was a pressure of 100 MPa.

A dye-sensitized solar cell [A-2] for comparison was obtained in the same manner as in Example 2 except that the flat pressing treatment was carried out instead of the roll-pressing treatment, and the values of the short-circuit current, open voltage, form factor ff and conversion efficiency of the dye-sensitized solar cell [A-2] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses before and after the pressing treatment were measured.

[Comparative Example A-3]

A Mini Test Press-10 (manufactured by Toyo Seiki Seisaku-sho, Ltd.) was used in a flat pressing treatment which substituted the roll-pressing treatment. A 5 mm-thick CONEX felt (manufactured by Du Pont Kabushiki Kaisha), a pressure-sensitive film ("PRESCALE", manufactured by Fujifilm Corporation), a translucent substrate, a fluorine mold release film and a 5 mm-thick CONEX felt (manufactured by Du Pont Kabushiki Kaisha) were sequentially laminated, and a laminate having a layer configuration of "CONEX felt"/"pressure-sensitive film"/"fluorine mold release film"/titania-coated ITO-PEN substrate/"CONEX felt" from the top was obtained. The laminate was pressed for 60 seconds while checking the actual pressing weight using the pressure-sensitive film. At this time, the weight was a pressure of 100 MPa.

A dye-sensitized solar cell [A-3] for comparison was obtained in the same manner as in Example 3 except that the flat pressing treatment was carried out instead of the roll-pressing treatment, and the values of the short-circuit current, open voltage, form factor ff and conversion efficiency of the dye-sensitized solar cell [A-3] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses before and after the pressing treatment were measured.

[Comparative Example A-4]

A Mini Test Press-10 (manufactured by Toyo Seiki Seisaku-sho, Ltd.) was used in a flat pressing treatment which substituted the roll-pressing treatment. A 5 mm-thick CONEX felt (manufactured by Du Pont Kabushiki Kaisha), a pressure-sensitive film ("PRESCALE", manufactured by Fujifilm Corporation), a translucent substrate, a fluorine mold release film and a 5 mm-thick CONEX felt (manufactured by Du Pont Kabushiki Kaisha) were sequentially laminated, and a laminate having a layer configuration of "CONEX felt"/"pressure-sensitive film"/"fluorine mold release film"/titania-coated ITO-PEN substrate/"CONEX felt" from the top was obtained. The laminate was pressed for 60 seconds while checking the actual pressing weight using the pressure-sensitive film. At this time, the weight was a pressure of 100 MPa.

A dye-sensitized solar cell [A-4] for comparison was obtained in the same manner as in Example 4 except that the flat pressing treatment was carried out instead of the roll-pressing treatment, and the values of the short-circuit current, open voltage, form factor ff and conversion efficiency of the dye-sensitized solar cell [A-4] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses before and after the pressing treatment were measured.

[Comparative Example A-5]

A Mini Test Press-10 (manufactured by Toyo Seiki Seisaku-sho, Ltd.) was used in a flat pressing treatment which substituted the roll-pressing treatment. A 5 mm-thick CONEX felt (manufactured by Du Pont Kabushiki Kaisha), a pressure-sensitive film ("PRESCALE", manufactured by Fujifilm Corporation), a translucent substrate, a fluorine mold release film and a 5 mm-thick CONEX felt (manufactured by Du Pont Kabushiki Kaisha) were sequentially laminated, and a laminate having a layer configuration of "CONEX felt"/"pressure-sensitive film"/"fluorine mold release film"/titania-coated ITO-PEN substrate/"CONEX felt" from the top was obtained. The laminate was pressed for 60 seconds while checking the actual pressing weight using the pressure-sensitive film. At this time, the weight was a pressure of 100 MPa.

A dye-sensitized solar cell [A-5] for comparison was obtained in the same manner as in Example 5 except that the flat pressing treatment was carried out instead of the roll-pressing treatment, and the values of the short-circuit current, open voltage, form factor ff and conversion efficiency of the dye-sensitized solar cell [A-5] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses before and after the pressing treatment were measured.

[Comparative Example A-6]

A Mini Test Press-10 (manufactured by Toyo Seiki Seisaku-sho, Ltd.) was used in a flat pressing treatment which substituted the roll-pressing treatment. A 5 mm-thick CONEX felt (manufactured by Du Pont Kabushiki Kaisha), a pressure-sensitive film ("PRESCALE", manufactured by Fujifilm Corporation), a translucent substrate, a fluorine mold release film and a 5 mm-thick CONEX felt (manufactured by Du Pont Kabushiki Kaisha) were sequentially laminated, and a laminate having a layer configuration of "CONEX felt"/"pressure-sensitive film"/"fluorine mold release film"/titania-coated ITO-PEN substrate/"CONEX felt" from the top was obtained. The laminate was pressed for 60 seconds while checking the actual pressing weight using the pressure-sensitive film. At this time, the weight was a pressure of 100 MPa.

A dye-sensitized solar cell [A-6] for comparison was obtained in the same manner as in Example 6 except that the flat pressing treatment was carried out instead of the roll-pressing treatment, and the values of the short-circuit current, open voltage, form factor ff and conversion efficiency of the dye-sensitized solar cell [A-6] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses before and after the pressing treatment were measured.

The data of Comparative Examples A-1 to A-6 are described in Table 2.

[Table 2]

| | Base material | Paste Titania A | Paste Titania B | Area | Pressing method | Pressing pressure |
|---|---|---|---|---|---|---|
| Comparative Example A-1 | PEN/ITO | 70 wt% | 30 wt% | 0.5 cm × 0.5 cm | Flat pressing | 100 MPa |
| Comparative Example A-2 | PEN/ITO | 100 wt% | - | 0.5 cm × 0.5 cm | Flat pressing | 100 MPa |
| Comparative Example A-3 | PEN/ITO | 60 wt% | 40 wt% | 0.5 cm × 0.5 cm | Flat pressing | 100 MPa |
| Comparative Example A-4 | PEN/ITO | 70 wt% | 30 wt% | 0.5 cm × 0.5 cm | Flat pressing | 100 MPa |
| Comparative Example A-5 | PEN/ITO | 70 wt% | 30 wt% | 0.5 cm × 4.5 cm | Flat pressing | 100 MPa |
| Comparative Example A-6 | PEN/ITO | PECC-K01 | | 0.5 cm × 0.5 cm | Flat pressing | 100 MPa |

| | Short-circuit current mA/cm² | Open voltage V | Form factor (-) | Conversion efficiency % | Presence or absence of pressing traces | Film thickness Before pressing (μm) | Film thickness After pressing (μm) | Transmittance % 500 nm | Transmittance % 700 nm |
|---|---|---|---|---|---|---|---|---|---|
| Comparative Example A-1 | 11.3 | 0.76 | 0.71 | 6.1 | Absence | 6.8 | 6.0 | 36.8 | 47.0 |
| Comparative Example A-2 | 10.0 | 0.78 | 0.74 | 5.8 | Absence | 7.2 | 6.1 | 70.2 | 78.8 |
| Comparative Example A-3 | 11.7 | 0.81 | 0.70 | 6.6 | Absence | 7.0 | 5.8 | 37.8 | 47.5 |
| Comparative Example A-4 | 10.1 | 0.80 | 0.70 | 5.7 | Absence | 7.0 | 5.9 | 36.4 | 43.7 |
| Comparative Example A-5 | 8.7 | 0.68 | 0.53 | 3.2 | Absence | 7.2 | 6.3 | 34.5 | 44.1 |
| Comparative Example A-6 | 10.1 | 0.77 | 0.73 | 5.7 | Absence | 7.4 | 6.0 | 30.2 | 41.3 |

[Comparative Example C-1]

A dye-sensitized solar cell [C-1] for comparison was obtained in the same manner as in Example 1 except that the coated film was not roll-pressed, but was heated at 150°C for 10 minutes, and the values of the short-circuit current, open voltage, form factor ff and conversion efficiency of the dye-sensitized solar cell [C-1] for comparison were obtained in the same manner as in Example 1. At this time, as a result of observing the surface of the obtained functional semiconductor layer using a SEM, traces extending in a specific direction, such as the roll-pressing traces, were not observed. In addition, the surface roughness Ra was measured in the same order as in Example 1, and the transmittance of the functional semiconductor with respect to the wavelength and the film thicknesses were measured. However, since the roll-pressing treatment was not carried out, the square section 300 was set at an arbitrary location, and a direction in which the measured value of the surface roughness Ra was small was considered as the first direction in the measurement of the surface roughness Ra.

As a result of measuring the surface roughness Ra, the surface roughness ratio was 45.0 nm/42.4 nm = 1.06, and the anisotropy in the surface roughness Ra between in the second direction and in the first direction was not confirmed.

[Comparative Example C-2]

A dye-sensitized solar cell [C-2] for comparison was obtained in the same manner as in Example 2 except that the coated film was not roll-pressed, but was heated at 150°C for 10 minutes, and the values of the short-circuit current, open voltage, form factor ff and conversion efficiency of the dye-sensitized solar cell [C-2] for comparison were obtained in the same manner as in Example 1. At this time, as a result of observing the surface of the obtained functional semiconductor layer using a SEM, traces extending in a specific direction, such as the roll-pressing traces, were not observed. In addition, the surface roughness Ra was measured in the same order as in Comparative Example C-1, and the transmittance of the functional semiconductor with respect to the wavelength and the film thicknesses were measured.

As a result of measuring the surface roughness Ra, the surface roughness ratio was 45.3 nm/43.0 nm = 1.05, and the anisotropy in the surface roughness Ra between in the second direction and in the first direction was not confirmed.

[Comparative Example C-3]

A dye-sensitized solar cell [C-3] for comparison was obtained in the same manner as in Example 6 except that the coated film was not roll-pressed, but was heated at 150°C for 10 minutes, and the values of the short-circuit current, open voltage, form factor ff and conversion efficiency of the dye-sensitized solar cell [C-3] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses were measured.

The data of Comparative Examples C-1 to C-3 are described in Table 3.

[Table 3]

| | Base material | Paste | | Area | Heating temperature | Heating time |
|---|---|---|---|---|---|---|
| | | Titania A | Titania B | | | |
| Comparative Example C-1 | PEN/ITO | 70 wt% | 30 wt% | 0.5 cm × 0.5 cm | 150°C | 10 min |
| Comparative Example C-2 | PEN/ITO | 100 wt% | - | 0.5 cm × 0.5 cm | 150°C | 10 min |
| Comparative Example C-3 | PEN/ITO | PECC-K01 | | 0.5 cm × 0.5 cm | 150°C | 10 min |

| | Short-circuit current $mA/cm^2$ | Open voltage V | Form factor (-) | Conversion efficiency % | Presence or absence of pressing traces | Surface roughness Ra in first direction nm | Surface roughness Ra in second direction nm | Surface roughness ratio | Film thickness after heating ($\mu m$) | Transmittance % | |
|---|---|---|---|---|---|---|---|---|---|---|---|
| | | | | | | | | | | 500 nm | 700 nm |
| Comparative Example C-1 | 9.8 | 0.75 | 0.66 | 4.9 | Absence | 42.4 | 45.0 | 1.06 | 7.2 | 30.5 | 42.1 |
| Comparative Example C-2 | 6.5 | 0.72 | 0.68 | 3.2 | Absence | 43.0 | 45.3 | 1.05 | 7.2 | 61.0 | 78.2 |
| Comparative Example C-3 | 8.7 | 0.72 | 0.61 | 3.8 | Absence | - | - | - | 6.8 | 22.8 | 37.0 |

[Comparative Example D-1]

A dye-sensitized solar cell [D-1] for comparison was obtained in the same manner as in Example 1 except that the coated film was not pressed and heated, but was held at room temperature for 10 minutes, and the values of the short-circuit current, open voltage, form factor ff and conversion efficiency of the dye-sensitized solar cell [D-1] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses were measured.

[Comparative Example D-2]

A dye-sensitized solar cell [D-2] for comparison was obtained in the same manner as in Example 2 except that the coated film was not pressed and heated, but was held at room temperature for 10 minutes, and the values of the short-circuit current, open voltage, form factor ff and conversion efficiency of the dye-sensitized solar cell [D-2] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses were measured.

[Comparative Example D-3]

A dye-sensitized solar cell [D-3] for comparison was obtained in the same manner as in Example 6 except that the coated film was not pressed and heated, but was held at room temperature for 10 minutes, and the values of the short-circuit current, open voltage, form factor ff and conversion efficiency of the dye-sensitized solar cell [D-3] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses were measured.

The data of Comparative Examples D-1 to D-3 are described in Table 4.

[Table 4]

| | Base material | Paste | | Area | Temperature conditions | Holding time |
|---|---|---|---|---|---|---|
| | | Titania A | Titania B | | | |
| Comparative Example D-1 | PEN/ITO | 70 wt% | 30 wt% | 0.5 cm × 0.5 cm | Room temperature | 10 min |
| Comparative Example D-2 | PEN/ITO | 100 wt% | - | 0.5 cm × 0.5 cm | Room temperature | 10 min |
| Comparative Example D-3 | PEN/ITO | PECC-K01 | | 0.5 cm × 0.5 cm | Room temperature | 10 min |

| | Short-circuit current mA/cm$^2$ | Open voltage V | Form factor (-) | Conversion efficiency % | Presence or absence of pressing traces | Film thickness (μm) | Transmittance % | |
|---|---|---|---|---|---|---|---|---|
| | | | | | | | 500 nm | 700 nm |
| Comparative Example D-1 | 4.7 | 0.81 | 0.71 | 2.7 | Absence | 6.5 | 31.0 | 42.6 |
| Comparative Example D-2 | 3.9 | 0.74 | 0.62 | 1.8 | Absence | 6.7 | 62.0 | 79.7 |
| Comparative Example D-3 | 4.3 | 0.75 | 0.63 | 2.0 | Absence | 6.8 | 18.4 | 31.1 |

[Comparative Example E-1]

A dye-sensitized solar cell [E-1] for comparison was obtained in the same manner as in Example 1 except that an FTO/conductive glass substrate having a surface resistance of 9 Ω/□ was used as the translucent substrate instead of the ITO/PEN substrate, the pressing was not carried out, the aqueous paste for forming the photoelectric conversion layer [1] was applied to, dried, and then sintered at 520°C for 1 hour, and an electrode having platinum sputtered onto conductive glass was used as the counter electrode, and the values of the short-circuit current, open voltage, form factor ff and conversion efficiency of the dye-sensitized solar cell [E-1] for comparison were obtained in the same manner as in Example 1. At this time, as a result of observing the surface of the obtained functional semiconductor layer using a SEM, traces extending in a specific direction, such as the roll-pressing traces, were not observed. In addition, the transmittance of the functional semiconductor with respect to the wavelength and the film thicknesses were measured.
The data of Comparative Example E-1 are described in Table 5.

[Table 5]

| | Base material | Paste | | Area | Heating temperature | Heating time |
|---|---|---|---|---|---|---|
| | | Titania A | Titania B | | | |
| Comparative Example E-1 | FTO/glass | 70 wt% | 30 wt% | 0.5 cm × 0.5 cm | 520°C | 1 h |

| | Short-circuit current mA/cm$^2$ | Open voltage V | Form factor (-) | Conversion efficiency % | Presence or absence of pressing traces | Film thickness after heating (μm) | Transmittance % | |
|---|---|---|---|---|---|---|---|---|
| | | | | | | | 500 nm | 700 nm |
| Comparative Example E-1 | 12.6 | 0.78 | 0.72 | 7.0 | Absence | 7.2 | 28.33 | 37.39 |

It was confirmed that high conversion efficiency was obtained in the dye-sensitized solar cells of the present invention according to Examples 1 to 6.

In addition, it was confirmed from the comparison of the results of Examples 1 and 5 that, when the working electrode section was set to be large, there was a tendency for the influence on the degree of the conversion efficiency to somewhat decrease, but almost the same conversion efficiency could be obtained. Regarding this aspect, the fact that the conversion efficiency significantly decreased in Comparative Example A-5, in which the working electrode section was increased, compared to in Comparative Example A-1 showed the superiority of the roll-pressing treatment to flat pressing.

On the other hand, it was confirmed from the results of Comparative Examples D-1, D-2 and D-3 regarding the dye-sensitized solar cells for comparison in which the coated films were not pressed that, when the coated film was not pressed, high conversion efficiency could not be obtained. This was considered to be mainly because the absence of the pressing decreased the junction property between the titania particles and the junction property between the titania particles and the translucent substrate.

In addition, it was confirmed from the results of Example 2 that a solar cell, in which only one kind of semiconductor particles having a small particle diameter were used, could not obtain higher conversion efficiency than the solar cell of the present invention, in which two kinds of semiconductor particles having different particle diameters were used, but it was possible to manufacture a dye-sensitized solar cell having a high transmittance.

Roll-pressing traces were observed in Examples 1 to 6, in which the coated films were roll-pressed, using a SEM. It was confirmed that the roll-pressing traces were generated so as to extend in parallel with the rolling direction of the roll press. In addition, as a result of comparing the surface roughness Ra between in the first direction that was in parallel with the roll-pressing treatment direction and in the second direction that was orthogonal to the first direction in the measurement of the surface roughness Ra of the functional semiconductor layer using an AFM, the surface roughness Ra in the second direction was larger than the surface roughness Ra in the first direction, and showed values 1.2 times or more the surface roughness Ra in the first direction. This difference was considered to have resulted from the unevenness of the roll-pressing traces generated by the roll-pressing treatment extending in the first direction.

In Comparative Examples A-1 to A-6 in which the samples were manufactured using flat pressing, traces extending in a specific direction, such as the roll-pressing trace, were not observed.

[Example F-1]

A dye-sensitized solar cell [F-1] was obtained in the same manner as in Example 1 except that the condition of the roll-pressing treatment was 80 MPa, and the same measurements as in Example 1 were carried out on the dye-sensitized solar cell [F-1] and a photoelectrode structure [F-1-1].

[Example F-2]

A dye-sensitized solar cell [F-2] was obtained in the same manner as in Example 1 except that the condition of the roll-pressing was 160 MPa, and the same measurements as in Example 1 were carried out on the dye-sensitized solar cell [F-2] and a photoelectrode structure [F-2-1].

[Comparative Example G-1]

A dye-sensitized solar cell [G-1] was obtained in the same manner except that the film thickness of the functional semiconductor was more increased than in Example 1, and the values of the short-circuit current, open voltage, form factor ff and conversion efficiency of the dye-sensitized solar cell [G-1] were obtained in the same manner as in Example 1.

At this time, the surface of the obtained functional semiconductor layer was observed using a SEM, and roll-pressing traces extending in parallel with the roll-pressing treatment direction were observed.

In addition, the transmittance of the functional semiconductor with respect to the wavelength and the film thicknesses before and after the roll-pressing were measured.

[Comparative Example G-2]

A dye-sensitized solar cell [G-2] was obtained in the same manner except that the film thickness of the functional semiconductor was more decreased than in Example 1, and the values of the short-circuit current, open voltage, form factor ff and conversion efficiency of the dye-sensitized solar cell [G-2] were obtained in the same manner as in Example 1.

At this time, the surface of the obtained functional semiconductor layer was observed using a SEM, and roll-pressing traces extending in parallel with the roll-pressing treatment direction were observed.

In addition, the transmittance of the functional semiconductor with respect to the wavelength and the film thicknesses before and after the roll-pressing were measured.

[Example H-1]

A dye-sensitized solar cell [H-1] was obtained by coating the aqueous paste for forming the photoelectric conversion layer [1], which was obtained in the same manner as in Example 1, so as to form a functional semiconductor layer, carrying out a UV-ozone treatment on the functional semiconductor layer, and then supporting a sensitizer, and the values of the short-circuit current, open voltage, form factor ff and conversion efficiency of the dye-sensitized solar cell [H-1] were obtained in the same manner as in Example 1.

(UV-ozone treatment)

A treatment subject was fed into a UV-ozone cleaning apparatus "OC-2506" (manufactured by Iwasaki Electric Co., Ltd.), and irradiated with ultraviolet rays for 5 minutes.

The data of Comparative Examples F-1 to H-1 are described in Table 6.

[Table 6]

| | Base material | Paste | | Area | Pressing method | Pressing pressure |
|---|---|---|---|---|---|---|
| | | Titania A | Titania B | | | |
| Example F-1 | PEN/ITO | 70 wt% | 30 wt% | 0.5 cm × 0.5 cm | Roll-pressing | 80 MPa |
| Example F-2 | PEN/ITO | 70 wt% | 30 wt% | 0.5 cm × 0.5 cm | Roll-pressing | 160 MPa |
| Example G-1 | PEN/ITO | 70 wt% | 30 wt% | 0.5 cm × 0.5 cm | Roll-pressing | 100 MPa |
| Example G-2 | PEN/ITO | 70 wt% | 30 wt% | 0.5 cm × 0.5 cm | Roll-pressing | 100 MPa |
| Example H-1 | PEN/ITO | 70 wt% | 30 wt% | 0.5 cm × 0.5 cm | Roll-pressing | 100 MPa |

| | Short-circuit current mA/cm$^2$ | Open voltage V | Form factor (-) | Conversion efficiency % | Presence or absence of pressing traces | Film thickness | | Transmittance % | |
|---|---|---|---|---|---|---|---|---|---|
| | | | | | | Before pressing (µm) | After pressing (µm) | 500 nm | 700 nm |
| Example F-1 | 11.6 | 0.79 | 0.69 | 6.3 | Presence | 7.4 | 5.0 | 41.2 | 52.2 |
| Example F-2 | 11.9 | 0.78 | 0.67 | 6.2 | Presence | 7.4 | 5.4 | 40.1 | 50.9 |
| Example G-1 | 11.4 | 0.80 | 0.72 | 6.6 | Presence | 11.8 | 10.5 | 27.3 | 38.9 |
| Example G-2 | 9.2 | 0.80 | 0.70 | 5.1 | Presence | 4.4 | 3.1 | 45.0 | 59.2 |
| Example H-1 | 13.0 | 0.78 | 0.65 | 6.6 | Presence | 13.1 | 8.9 | 34.0 | 43.0 |

It was shown that high conversion efficiency could be obtained by carrying out the UV-ozone treatment on the functional semiconductor layer compared to a case in which the UV-ozone treatment was not carried out, for example, Example 1.

This was assumed to be because the UV-ozone treatment on the functional semiconductor layer increased the hydrophilic groups of the semiconductor particles included in the functional semiconductor layer so as to make the semiconductor particles easily adsorbable, and, consequently, the obtained dye-sensitized solar cell could obtain high conversion efficiency.

Next, examples corresponding to the second embodiment will be described.

[Example 11]

(Formation of the second layer)

The titania particles [B] were condensed by almost fully substituting the solvent into water using an evaporator, thereby, finally, obtaining paste for forming the photoelectric conversion layer [2] in which the concentration of the titania particles was 10 wt%, and water was used as the solvent.

The paste for forming the photoelectric conversion layer [2] was applied to the roll-pressed functional semiconductor layer again using the doctor blade method so as to superimpose the roll-pressed functional semiconductor layer, which was formed in the same order as in Example 1, and dried at room temperature, thereby obtaining a coated film. After that, the coated film was flat-pressed using a Mini Test Press-10 (manufactured by Toyo Seiki Seisaku-sho, Ltd.), thereby forming a functional semiconductor layer which was to serve as the second layer.

Specifically, a 5 mm-thick CONEX felt (manufactured by Du Pont Kabushiki Kaisha), a pressure-sensitive film ("PRESCALE", manufactured by Fujifilm Corporation), a titania-coated ITO-PEN substrate, a fluorine mold release film and a 5 mm-thick CONEX felt (manufactured by Du Pont Kabushiki Kaisha) were sequentially laminated, and a laminate having a layer configuration of "CONEX felt"/"pressure-sensitive film"/"fluorine mold release film"/titania-coated ITO-PEN substrate/"CONEX felt" from the top was obtained. The laminate was pressed for 60 seconds while checking the actual pressing weight using the pressure-sensitive film. At this time, the weight was a pressure of 100 MPa. A photoelectrode structure having the first layer and the second layer formed on the translucent substrate was obtained in the above order.

After that, the sensitizer was supported in the same manner as in Example 1 so as to obtain a photoelectrode, and, furthermore, a dye-sensitized solar cell was manufactured.

[Example 12]

A roll-pressing treatment was carried out using the roll-pressing machine having a metal roll instead of the flat pressing treatment in Example 11. The roll-pressing treatment was carried out using the roll-pressing machine by rotating a roll press having a diameter of 25 cm at a predetermined pressing pressure and 1 rpm. The pressure of the roll press was carried out while adjusting the clearance and confirming the load using a pressure-sensitive film (PRESCALE, manufactured by Fujifilm Corporation). Meanwhile, the pressure-sensitive film was disposed on the surface of the substrate, on which the titania-coated film was not formed. The pressing pressure was set by adjusting the roll clearance while checking the actual pressing load using the pressure-sensitive film. The paste was roll-pressed from both surfaces at a pressure of 100 MPa.

A photoelectrode structure having the first layer and the second layer formed on the translucent substrate was obtained in the above order.

After that, the sensitizer was supported in the same manner as in Example 1 so as to obtain a photoelectrode, and, furthermore, a dye-sensitized solar cell was manufactured.

[Example 13]

A dye-sensitized solar cell was manufactured in the same order as in Example 12 except that a semiconductor layer, which was to serve as the second layer, was obtained through heating and drying at 150°C for 10 minutes instead of the roll-pressing treatment of Example 12.

[Example 14]

A dye-sensitized solar cell was manufactured in the same order as in Example 12 except that a semiconductor layer, which was to serve as the second layer, was obtained through drying at room temperature for 10 minutes instead of the roll-pressing treatment of Example 12.

When the photoelectrode structures of Examples 11 to 14 were put into pure water, and ultrasonic waves were radiated on the surfaces of the photoelectric conversion layers in water for 5 seconds, the second layer was detached from the first layer. After that, the surface of the first layer was observed using a microscope at a magnification of 1000 times, and roll-pressing traces could be confirmed.

The configurations of Examples 11 to 14 are summarized in Table 7. In addition, the evaluation results of the battery performances of Examples 11 to 14 using the above method are described in Table 8. As described in Table 8, the battery performance improved in the dye-sensitized solar cell of the examples provided with the second layer compared to the examples not having the second layer.

[Table 7]

| | Base material | Paste | | Area | Method for pressing first layer | Pressing pressure | Method for forming second layer |
| | | Titania A | Titania B | | | | |
|---|---|---|---|---|---|---|---|
| Example 11 | PEN/ITO | 70 wt% | 30 wt% | 0.5 cm × 0.5 cm | Roll-pressing | 100 MPa | Flat pressing |
| Example 12 | PEN/ITO | 70 wt% | 30 wt% | 0.5 cm × 0.5 cm | Roll-pressing | 100 MPa | Roll-pressing |
| Example 13 | PEN/ITO | 70 wt% | 30 wt% | 0.5 cm × 0.5 cm | Roll-pressing | 100 MPa | 150°C-10 min |
| Example 14 | PEN/ITO | 70 wt% | 30 wt% | 0.5 cm × 0.5 cm | Roll-pressing | 100 MPa | Room temperature-10 min |

[Table 8]

| Sample No. | First layer | Second layer | Roll traces after detachment of second layer | Current mA/cm$^2$ | Voltage V | Form factor (-) | Conversion efficiency % |
|---|---|---|---|---|---|---|---|
| Example 11 | Roll-pressing | Flat pressing | Presence | 12.6 | 0.77 | 0.71 | 6.9 |
| Example 12 | Roll-pressing | Roll-pressing | Presence | 13.3 | 0.77 | 0.66 | 6.8 |
| Example 13 | Roll-pressing | 150°C-10 min | Presence | 13.5 | 0.76 | 0.69 | 7.2 |
| Example 14 | Roll-pressing | Drying at room temperature | Presence | 12.6 | 0.79 | 0.71 | 7.0 |

From the above results, it was shown that higher conversion efficiency can be obtained by laminating the second layer on the roll-pressed first layer than that of the comparative example only having the first layer. This was assumed to be because the second layer functioned as a light-scattering layer, and the optical confinement effect was strongly developed.

Next, examples corresponding to the third embodiment will be described.

[Example 21]

A photoelectrode and a dye-sensitized solar cell were manufactured in the same manner as in Example 1 except that a Ti substrate (thickness 40 $\mu$m) was used as the substrate that formed the photoelectric conversion layer, and an electrode having platinum evaporated onto a ITO/PEN film (manufactured by Tobi Co., Ltd.) having a surface resistance of 13 $\Omega/\square$ was used as the counter electrode, and the battery performance was evaluated using the same method as in Example 1.

As a result of observing the 1000-time and 20000-time magnified SEM photographs of the coated film formed on the Ti substrate after the roll-pressing treatment, roll-pressing traces extending in parallel with the roll-pressing treatment direction were confirmed.

As a result of measuring the surface roughness ratio using the same method as in Example 1, the surface roughness ratio was 18.3 nm/13.8 nm = 1.33, and the anisotropy in the surface roughness Ra between in the second direction and in the first direction was confirmed.

[Example 22]

A photoelectrode and a dye-sensitized solar cell were manufactured in the same manner as in Example 21 except that paste containing only the titania particles [A] was used, and the battery performance was evaluated using the same method as in Example 1.

At this time, the surface of the obtained functional semiconductor layer was observed using a SEM, and roll-pressing traces extending in parallel with the roll-pressing treatment direction were confirmed. In addition, the surface roughness Ra was measured in the same order as in Example 1, and the film thicknesses before and after the roll-pressing were measured.

As a result of measuring the surface roughness Ra, the surface roughness ratio was 30.3 nm/19.8 nm = 1.53, and the anisotropy in the surface roughness Ra between in the second direction and in the first direction was confirmed.

[Example 23]

A photoelectrode and a dye-sensitized solar cell were manufactured in the same manner as in Example 21 except that paste having the titania particles [A] and the titania particles [B] mixed at a weight ratio of 6:4 was used, and the battery performance was evaluated using the same method as in Example 1.

At this time, the surface of the obtained functional semiconductor layer was observed using a SEM, and roll-pressing traces extending in parallel with the roll-pressing treatment direction were confirmed. In addition, the surface roughness Ra was measured in the same order as in Example 1, and the film thicknesses before and after the roll-pressing were measured.

As a result of measuring the surface roughness Ra, the surface roughness ratio was 27.8 nm/14.6 nm = 1.90, and the anisotropy in the surface roughness Ra between in the second direction and in the first direction was confirmed.

[Example 24]

A photoelectrode and a dye-sensitized solar cell were manufactured in the same manner as in Example 21 except that a Cu substrate (thickness 40 $\mu$m) was used instead of the Ti substrate.

At this time, the surface of the obtained functional semiconductor layer was observed using a SEM, and roll-pressing traces extending in parallel with the roll-pressing treatment direction were confirmed. In addition, the surface roughness Ra was measured in the same order as in Example 1, and the film thicknesses before and after the roll-pressing were measured.

As a result of measuring the surface roughness Ra, the surface roughness ratio was 31.2 nm/12.6 nm = 2.48, and the anisotropy in the surface roughness Ra between in the second direction and in the first direction was confirmed.

[Example 25]

A photoelectrode and a dye-sensitized solar cell were manufactured in the same manner as in Example 21 except that an SUS304 substrate (thickness 50 $\mu$m) was used instead of the Ti substrate, and the battery performance was evaluated using the same method as in Example 1.

At this time, the surface of the obtained functional semiconductor layer was observed using a SEM, and roll-pressing traces extending in parallel with the roll-pressing treatment direction were confirmed. In addition, the surface roughness Ra was measured in the same order as in Example 1, and the film thicknesses before and after the roll-pressing were measured.

As a result of measuring the surface roughness Ra, the surface roughness ratio was 15.2 nm/11.7 nm = 1.30, and the anisotropy in the surface roughness Ra between in the second direction and in the first direction was confirmed.

[Example 26]

A photoelectrode and a dye-sensitized solar cell were manufactured in the same manner as in Example 21 except that the working electrode section was set to 0.5 cm x 4.5 cm, and the battery performance was evaluated using the same method as in Example 1.

At this time, the surface of the obtained functional semiconductor layer was observed using a SEM, and roll-pressing traces extending in parallel with the roll-pressing treatment direction were confirmed. In addition, the surface roughness Ra was measured in the same order as in Example 1, and the film thicknesses before and after the roll-pressing were measured.

As a result of measuring the surface roughness Ra, the surface roughness ratio was 17.1 nm/13.6 nm = 1.26, and the anisotropy in the surface roughness Ra between in the second direction and in the first direction was confirmed.

[Example 27]

A photoelectrode and a dye-sensitized solar cell were manufactured in the same manner as in Example 21 except that commercial paste "PECC-K01" (manufactured by Peccell Technologies, Inc.) was used as the paste, and the battery performance was evaluated using the same method as in Example 1.

At this time, the surface of the obtained functional semiconductor layer was observed using a SEM, and roll-pressing traces extending in parallel with the roll-pressing treatment direction were confirmed. In addition, the surface roughness Ra was measured in the same order as in Example 1, and the film thicknesses before and after the roll-pressing were measured.

As a result of measuring the surface roughness Ra, the surface roughness ratio was 23.6 nm/15.9 nm = 1.48, and the anisotropy in the surface roughness Ra between in the second direction and in the first direction was confirmed.

The results of Examples 21 to 27 are described in Table 9. Only the values of the film thicknesses of the functional semiconductor layers after the roll-pressing are described. In addition, it was confirmed that Example 24 functioned as a battery, but the battery performance was not measured.

[Table 9]

| | Substrate | Paste | | Method for forming film | Pressing pressure | Area | Film thickness | Presence or absence of pressing traces |
|---|---|---|---|---|---|---|---|---|
| | | Titania A | Titania B | | | | | |
| Example 21 | Ti | 70 wt% | 30 wt% | Roll-pressing | 100 MPa | 0.5 cm × 0.5 cm | 6 μm | Presence |
| Example 22 | Ti | 100 wt% | - | Roll-pressing | 100 MPa | 0.5 cm × 0.5 cm | 6 μm | Presence |
| Example 23 | Ti | 60 wt% | 40 wt% | Roll-pressing | 100 MPa | 0.5 cm × 0.5 cm | 6 μm | Presence |
| Example 24 | Cu | 70 wt% | 30 wt% | Roll-pressing | 100 MPa | 0.5 cm × 0.5 cm | 6 μm | Presence |
| Example 25 | SUS | 70 wt% | 30 wt% | Roll-pressing | 100 MPa | 0.5 cm × 0.5 cm | 6 μm | Presence |
| Example 26 | Ti | 70 wt% | 30 wt% | Roll-pressing | 100 MPa | 0.5 cm × 4.5 cm | 6 μm | Presence |
| Example 27 | Ti | PECC-K01 | | Roll-pressing | 100 MPa | 0.5 cm × 0.5 cm | 6 μm | Presence |

| | AFM | | | Battery performance | | | |
|---|---|---|---|---|---|---|---|
| | Surface roughness Ra in first direction nm | Surface roughness Ra in second direction nm | Surface roughness ratio | Short-circuit current mA/cm$^2$ | Open voltage V | Form factor (-) | Conversion efficiency % |
| Example 21 | 13.8 | 18.3 | 1.33 | 6.5 | 0.78 | 0.76 | 3.8 |
| Example 22 | 19.8 | 30.3 | 1.53 | 5.9 | 0.78 | 0.76 | 3.5 |
| Example 23 | 14.6 | 27.8 | 1.90 | 5.9 | 0.77 | 0.71 | 3.3 |
| Example 24 | 12.6 | 31.2 | 2.48 | - | - | - | - |
| Example 25 | 11.7 | 15.2 | 1.30 | 7.5 | 0.61 | 0.44 | 2.0 |
| Example 26 | 13.6 | 17.1 | 1.26 | 5.9 | 0.69 | 0.76 | 3.1 |
| Example 27 | 15.9 | 23.6 | 1.48 | 6.3 | 0.76 | 0.66 | 3.1 |

[Comparative Example A-21]

A photoelectrode and a dye-sensitized solar cell were manufactured in the same manner as in Example 21 except that flat pressing treatment was carried out instead of the roll-pressing treatment, and the battery performance was evaluated using the same method as in Example 1.

A Mini Test Press-10 (manufactured by Toyo Seiki Seisaku-sho, Ltd.) was used in the flat pressing treatment. A 5 mm-thick CONEX felt (manufactured by Du Pont Kabushiki Kaisha), a pressure-sensitive film ("PRESCALE", manufactured by Fujifilm Corporation), a Ti substrate, a fluorine mold release film and a 5 mm-thick CONEX felt (manufactured by Du Pont Kabushiki Kaisha) were sequentially laminated, and a laminate having a layer configuration of "CONEX felt"/"pressure-sensitive film"/"fluorine mold release film"/titania-coated Ti substrate/"CONEX felt" from the top was obtained. The laminate was pressed for 60 seconds while checking the actual pressing weight using the pressure-sensitive film. At this time, the weight was a pressure of 100 MPa.

At this time, as a result of observing the surface of the obtained functional semiconductor layer using a SEM, traces extending in a specific direction, such as the roll-pressing traces, were not observed.

In addition, the surface roughness Ra was measured in the same order as in Example 1, and the film thicknesses before and after the roll-pressing were measured. However, since the roll-pressing treatment was not carried out, the square section 300 was set at an arbitrary location, and a direction in which the measured value of the surface roughness Ra was small was considered as the first direction in the measurement of the surface roughness Ra.

As a result of measuring the surface roughness Ra, the surface roughness ratio was 41.3 nm/38.2 nm = 1.08, and the anisotropy in the surface roughness Ra between in the second direction and in the first direction was not confirmed.

[Comparative Example A-22]

A photoelectrode and a dye-sensitized solar cell were manufactured in the same manner as in Example 22 except that the same flat pressing treatment as in Comparative Example A-21 was carried out instead of the roll-pressing treatment, and the battery performance was evaluated using the same method as in Example 1.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 35.2 nm/30.9 nm = 1.14, and the anisotropy in the surface roughness Ra between in the second direction and in the first direction was not confirmed.

[Comparative Example A-23]

A photoelectrode and a dye-sensitized solar cell were manufactured in the same manner as in Example 23 except that the same flat pressing treatment as in Comparative Example A-21 was carried out instead of the roll-pressing treatment, and the battery performance was evaluated using the same method as in Example 1.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 35.6 nm/30.7 nm = 1.16.

[Comparative Example A-24]

A photoelectrode and a dye-sensitized solar cell were manufactured in the same manner as in Example 24 except that the same flat pressing treatment as in Comparative Example A-21 was carried out instead of the roll-pressing treatment.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 37.4 nm/31.8 nm = 1.18, and the anisotropy in the surface roughness Ra between in the second direction and in the first direction was not confirmed.

[Comparative Example A-25]

A photoelectrode and a dye-sensitized solar cell were manufactured in the same manner as in Example 25 except that the same flat pressing treatment as in Comparative Example A-21 was carried out instead of the roll-pressing treatment, and the battery performance was evaluated using the same method as in Example 1.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 32.8 nm/31.7 nm = 1.03, and the anisotropy in the surface roughness Ra between in the second direction and in the first direction was not confirmed.

[Comparative Example A-26]

A photoelectrode and a dye-sensitized solar cell were manufactured in the same manner as in Example 26 except that the same flat pressing treatment as in Comparative Example A-21 was carried out instead of the roll-pressing treatment, and the battery performance was evaluated using the same method as in Example 1.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 28.6 nm/27.4 nm = 1.04, and the anisotropy in the surface roughness Ra between in the second direction and in the first direction was not confirmed.

[Comparative Example A-27]

A photoelectrode and a dye-sensitized solar cell were manufactured in the same manner as in Example 27 except that the same flat pressing treatment as in Comparative Example A-21 was carried out instead of the roll-pressing treatment, and the battery performance was evaluated using the same method as in Example 1.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 47.6 nm/43.8 nm = 1.09, and the anisotropy in the surface roughness Ra between in the second direction and in the first direction was not confirmed.

The results of Comparative Examples A-21 to A-27 are described in Table 10. Only the values of the film thicknesses of the functional semiconductor layers after the roll-pressing are described. In addition, it was confirmed that Comparative Example A-24 functioned as a battery, but the battery performance was not measured.

[Table 10]

| | | Paste | | Method for forming film | Pressing pressure | Area | Film thickness | Presence or absence of pressing traces |
|---|---|---|---|---|---|---|---|---|
| | Substrate | Titania A | Titania B | | | | | |
| Comparative Example A-21 | Ti | 70 wt% | 30 wt% | Flat pressing | 100 MPa | 0.5 cm × 0.5 cm | 6 μm | Absence |
| Comparative Example A-22 | Ti | 100 wt% | - | Flat pressing | 100 MPa | 0.5 cm × 0.5 cm | 6 μm | Absence |
| Comparative Example A-23 | Ti | 60 wt% | 40 wt% | Flat pressing | 100 MPa | 0.5 cm × 0.5 cm | 6 μm | Absence |
| Comparative Example A-24 | Cu | 70 wt% | 30 wt% | Flat pressing | 100 MPa | 0.5 cm × 0.5 cm | 6 μm | Absence |
| Comparative Example A-25 | SUS | 70 wt% | 30 wt% | Flat pressing | 100 MPa | 0.5 cm × 0.5 cm | 6 μm | Absence |
| Comparative Example A-26 | Ti | 70 wt% | 30 wt% | Flat pressing | 100 MPa | 0.5 cm × 4.5 cm | 6 μm | Absence |
| Comparative Example A-27 | Ti | PECC-K01 | | Flat pressing | 100 MPa | 0.5 cm × 0.5 cm | 6 μm | Absence |

| | AFM | | | Battery performance | | | |
|---|---|---|---|---|---|---|---|
| | Surface roughness Ra in first direction nm | Surface roughness Ra in second direction nm | Surface roughness ratio | Short-circuit current mA/cm$^2$ | Open voltage V | Form factor (-) | Conversion efficiency % |
| Comparative Example A-21 | 38.2 | 41.3 | 1.08 | 5.9 | 0.78 | 0.76 | 3.5 |
| Comparative Example A-22 | 30.9 | 35.2 | 1.14 | 5.5 | 0.79 | 0.77 | 3.4 |
| Comparative Example A-23 | 30.7 | 35.6 | 1.16 | 4.9 | 0.79 | 0.74 | 2.8 |
| Comparative Example A-24 | 31.8 | 37.4 | 1.18 | - | - | - | - |
| Comparative Example A-25 | 31.7 | 32.8 | 1.03 | 8.1 | 0.57 | 0.44 | 2.1 |
| Comparative Example A-26 | 27.4 | 28.6 | 1.04 | 1.1 | 0.53 | 0.31 | 0.2 |
| Comparative Example A-27 | 43.8 | 47.6 | 1.09 | 4.0 | 0.78 | 0.69 | 2.2 |

[Comparative Example C-21]

A photoelectrode and a dye-sensitized solar cell were manufactured in the same manner as in Example 21 except that the coated film was not pressed, but was dried at room temperature for 10 minutes, and the battery performance was evaluated using the same method as in Example 1.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 67.5 nm/59.1 nm = 1.14, and the anisotropy in the surface roughness Ra between in the second direction and in the first direction was not confirmed.

[Comparative Example C-22]

A photoelectrode and a dye-sensitized solar cell were manufactured in the same manner as in Example 24 except that the coated film was not pressed, but was dried at room temperature for 10 minutes.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 149.6 nm/128.8 nm = 1.16, and the anisotropy in the surface roughness Ra between in the second direction and in the first direction was not confirmed.

[Comparative Example C-23]

A photoelectrode and a dye-sensitized solar cell were manufactured in the same manner as in Example 25 except that the coated film was not pressed, but was dried at room temperature for 10 minutes, and the battery performance was evaluated using the same method as in Example 1.

At this time, as a result of observing the surface of the obtained functional semiconductor layer using a SEM, traces extending in a specific direction, such as the roll-pressing traces, were not observed. In addition, the surface roughness Ra was measured in the same order as in Comparative Example A-21, and the film thicknesses before and after the roll-pressing were measured.

As a result of measuring the surface roughness Ra, the surface roughness ratio was 61.6 nm/61.4 nm = 1.00, and the anisotropy in the surface roughness Ra between in the second direction and in the first direction was not confirmed.

The results of Comparative Examples C-21 to C-23 are described in Table 11. It was confirmed that Comparative Example C-22 functioned as a battery, but the battery performance was not measured.

[Table 11]

| | Substrate | Paste | | Method for forming film | Pressing pressure | Area | Film thickness | Presence or absence of pressing traces |
|---|---|---|---|---|---|---|---|---|
| | | Titania A | Titania B | | | | | |
| Comparative Example C-21 | Ti | 70 wt% | 30 wt% | Drying at room temperature | - | 0.5 cm × 0.5 cm | 6 μm | Absence |
| Comparative Example C-22 | Cu | 70 wt% | 30 wt% | Drying at room temperature | - | 0.5 cm × 0.5 cm | 6 μm | Absence |
| Comparative Example C-23 | SUS | 70 wt% | 30 wt% | Drying at room temperature | - | 0.5 cm × 0.5 cm | 6 μm | Absence |

| | AFM | | | Battery performance | | | |
|---|---|---|---|---|---|---|---|
| | Surface roughness Ra in first direction nm | Surface roughness Ra in second direction nm | Surface roughness ratio | Short-circuit current mA/cm$^2$ | Open voltage V | Form factor (-) | Conversion efficiency % |
| Comparative Example C-21 | 59.1 | 67.5 | 1.14 | 1.8 | 0.78 | 0.74 | 1.0 |
| Comparative Example C-22 | 128.8 | 149.7 | 1.16 | - | - | - | - |
| Comparative Example C-23 | 61.4 | 61.6 | 1.00 | 1.3 | 0.55 | 0.06 | 0.1 |

It was confirmed that high conversion efficiency was obtained in the dye-sensitized solar cells of the present invention according to Examples 21 to 27.

In addition, it was confirmed from the comparison of the results of Examples 21 and 26 that, when the working electrode section was set to be large, there was a tendency for the influence on the degree of the conversion efficiency to somewhat decrease, but almost the same conversion efficiency could be obtained. Regarding this aspect, the fact that the conversion efficiency significantly decreased in Comparative Example A-26, in which the working electrode section was increased, compared to in Comparative Example A-21 showed the superiority of the roll-pressing treatment to flat pressing.

On the other hand, it was confirmed from the results of Comparative Example C-21 regarding the dye-sensitized solar cells for comparison in which the coated films were not pressed that, when the coated film was not pressed, high conversion efficiency could not be obtained. This is considered to be mainly because the absence of the pressing decreased the junction property between the titania particles and the junction property between the titania particles and the translucent substrate.

Roll-pressing traces were observed in Examples 21 to 27, in which the coated films were roll-pressed, using a SEM. It was confirmed that the roll-pressing traces were generated so as to extend in parallel with the rolling direction of the roll press.

[Example D-21]

A photoelectrode and a dye-sensitized solar cell were manufactured in the same manner as in Example 21 except that the condition of the roll-pressing treatment was 80 MPa, and the battery performance was evaluated using the same method as in Example 1.

At this time, as a result of observing the surface of the obtained functional semiconductor layer using a SEM, traces extending in a specific direction, such as the roll-pressing traces, were confirmed. In addition, the surface roughness Ra was measured in the same order as in Example 1, and the film thicknesses before and after the roll-pressing were measured.

As a result of measuring the surface roughness Ra, the surface roughness ratio was 17.4 nm/13.6 nm = 1.28, and the anisotropy in the surface roughness Ra between in the second direction and in the first direction was confirmed.

[Example D-22]

A photoelectrode and a dye-sensitized solar cell were manufactured in the same manner as in Example 21 except that the condition of the roll-pressing was 160 MPa, and the battery performance was evaluated using the same method as in Example 1.

At this time, as a result of observing the surface of the obtained functional semiconductor layer using a SEM, traces extending in a specific direction, such as the roll-pressing traces, were confirmed. In addition, the surface roughness Ra was measured in the same order as in Example 1, and the film thicknesses before and after the roll-pressing were measured.

As a result of measuring the surface roughness Ra, the surface roughness ratio was 20.5 nm/12.6 nm = 1.63, and the anisotropy in the surface roughness Ra between in the second direction and in the first direction was confirmed.

[Comparative Example E-21]

A photoelectrode and a dye-sensitized solar cell were manufactured in the same manner as in Example 21 except that the film thickness of the roll-pressed functional semiconductor was 2 $\mu$m, which was thinner than that of Example 21, by controlling the amount of the aqueous paste for forming the photoelectric conversion layer [1] applied, and the battery performance was evaluated using the same method as in Example 1.

At this time, as a result of observing the surface of the obtained functional semiconductor layer using a SEM, traces extending in a specific direction, such as the roll-pressing traces, were confirmed. In addition, the surface roughness Ra was measured in the same order as in Example 1, and the film thicknesses before and after the roll-pressing were measured.

As a result of measuring the surface roughness Ra, the surface roughness ratio was 37.1 nm/18.5 nm = 2.01, and the anisotropy in the surface roughness Ra between in the second direction and in the first direction was confirmed.

[Comparative Example E-22]

A photoelectrode and a dye-sensitized solar cell were manufactured in the same manner as in Example 21 except that the film thickness of the roll-pressed functional semiconductor was 10 $\mu$m, which was thicker than that of Example 21, by controlling the amount of the aqueous paste for forming the photoelectric conversion layer [1] applied, and the battery performance was evaluated using the same method as in Example 1.

At this time, as a result of observing the surface of the obtained functional semiconductor layer using a SEM, traces extending in a specific direction, such as the roll-pressing traces, were confirmed. In addition, the surface roughness Ra was measured in the same order as in Example 1, and the film thicknesses before and after the roll-pressing were measured.

As a result of measuring the surface roughness Ra, the surface roughness ratio was 24.1 nm/16.7 nm = 1.44, and the anisotropy in the surface roughness Ra between in the second direction and in the first direction was confirmed.

The results of Examples D-21 to E-22 are described in Table 12. Only the values of the film thicknesses of the functional semiconductor layers after the roll-pressing are described.

[Table 12]

| | Substrate | Paste | | Method for forming film | Pressing pressure | Area | Film thickness | Presence or absence of pressing traces |
|---|---|---|---|---|---|---|---|---|
| | | Titania A | Titania B | | | | | |
| Example D-21 | Ti | 70 wt% | 30 wt% | Roll-pressing | 80 MPa | 0.5 cm × 0.5 cm | 6 μm | Presence |
| Example D-22 | Ti | 70 wt% | 30 wt% | Roll-pressing | 160 MPa | 0.5 cm × 0.5 cm | 6 μm | Presence |
| Example E-21 | Ti | 70 wt% | 30 wt% | Roll-pressing | 100 MPa | 0.5 cm × 0.5 cm | 2 μm | Presence |
| Example E-22 | Ti | 70 wt% | 30 wt% | Roll-pressing | 100 MPa | 0.5 cm × 0.5 cm | 10 μm | Presence |

| | AFM | | | Battery performance | | | |
|---|---|---|---|---|---|---|---|
| | Surface roughness Ra in first direction nm | Surface roughness Ra in second direction nm | Surface roughness ratio | Short-circuit current mA/cm$^2$ | Open voltage V | Form factor (-) | Conversion efficiency % |
| Example D-21 | 13.6 | 17.4 | 1.28 | 5.8 | 0.76 | 0.74 | 3.3 |
| Example D-22 | 12.6 | 20.5 | 1.63 | 4.5 | 0.77 | 0.74 | 2.6 |
| Example E-21 | 18.5 | 37.1 | 2.01 | 3.1 | 0.76 | 0.55 | 1.3 |
| Example E-22 | 16.7 | 24.1 | 1.44 | 7.9 | 0.73 | 0.76 | 4.4 |

EP 2 784 871 B1

Thus far, the present invention has been described based on the embodiments and the examples, but is not limited to the examples in any fashion, and it is needless to say that the present invention can be appropriately modified within the scope of the purport of the present invention.

The present invention can be applied to dye-sensitized solar cells.

**Claims**

1. A photoelectrode (20, 220) for a dye-sensitized solar cell (1, 201), comprising:

   a sensitizer supported in a functional semiconductor layer (23a) of a photoelectrode structure (20K) provided with the functional semiconductor layer (23a) on a transparent conductive layer (21b) of a translucent substrate (21) or on a metal substrate (221), the translucent substrate (21) being made by forming the transparent conductive layer (21b) on a plastic translucent support (21a),
   wherein the functional semiconductor layer (23a) includes a roll-pressed layer in contact with the transparent conductive layer (21b) or the metal substrate (221) and roll-pressing traces extending in parallel with a roll-pressing treatment direction on a surface of the roll-pressed layer, and
   a surface roughness Ra in a first direction which is in parallel with the roll-pressing treatment direction is smaller than a surface roughness Ra in a second direction which is orthogonal to the first direction on a surface of the functional semiconductor layer (23a), and the surface roughness Ra in the second direction is greater than or equal to 1.2 times the surface roughness Ra in the first direction.

2. The photoelectrode (20, 220) for a dye-sensitized solar cell (1, 201) according to Claim 1,
   wherein a light transmittance of a laminate made of the translucent substrate (21) and the roll-pressed layer of the functional semiconductor layer (23a) in the photoelectrode structure at a wavelength of 500 nm is 20% to 85%, and a light transmittance of the laminate at a wavelength of 700 nm is 30% to 85%.

3. The photoelectrode (20, 220) for a dye-sensitized solar cell (1, 201) according to Claim 1,

   wherein a thickness of the roll-pressed layer of the functional semiconductor layer (23a) is within 1 $\mu$m to 40 $\mu$m.

4. The photoelectrode (20, 220) for a dye-sensitized solar cell (1, 201) according to any one of Claims 1 to 3,

   wherein the functional semiconductor layer (23a) contains particles having an average particle diameter of 2 nm to 40 nm.

5. The photoelectrode (20, 220) for a dye-sensitized solar cell (1, 201) according to any one of Claims 1 to 4,

   wherein the functional semiconductor layer (23a) contains two or more kinds of particles having different average particle diameters, and the average particle diameter of at least one kind of particles is 2 nm to 40 nm.

6. The photoelectrode (20, 220) for a dye-sensitized solar cell (1, 201) according to Claim 5,

   wherein, in the two or more kinds of particles having different average particle diameters, a content ratio of particles having an average particle diameter of 2 nm to 40 nm is 50 mass% to 95 mass%.

7. A dye-sensitized solar cell (1, 201) comprising:

   the photoelectrode (20, 220) for a dye-sensitized solar cell (1, 201) according to any one of Claims 1 to 6,
   wherein the photoelectrode (20, 220) for a dye-sensitized solar cell (1, 201) is provided so as to face a counter electrode (16, 216) through an electrolyte portion (12).

8. A method for manufacturing a photoelectrode (20, 220) for a dye-sensitized solar cell (1) formed by laminating a photoelectric conversion layer (23) on a transparent conductive layer (21b) of a translucent substrate (21) or on a metal substrate (221), the translucent substrate (21) being produced by forming the transparent conductive layer (21b) on a plastic translucent support (21a), the photoelectric conversion layer (23) containing particles and a sensitizer,

the method comprising:

forming a coated film (23A) by applying paste containing the particles to the transparent conductive layer (21b) or the metal substrate (221), and then roll-pressing the coated film (23A) under a pressure of $5 \times 10^6$ Pa (5 MPa) to $5 \times 10^8$ Pa (500 MPa);

allowing a layer obtained by roll-pressing the coated film to support the sensitizer; and

forming roll-pressing traces having different surface roughnesses Ra on a surface of the coated film (23A) in a first direction and a second direction, the first direction being in parallel with a roll-pressing treatment direction, the second direction being orthogonal to the first direction when roll-pressing the coated film (23A), the surface roughness Ra in the second direction being greater than or equal to 1.2 times the surface roughness Ra in the first direction.

9. The method for manufacturing a photoelectrode (20, 220) for a dye-sensitized solar cell (1, 201) according to Claim 8,

wherein, in the translucent substrate (21), a surface of the transparent conductive layer (21b) is subjected to a UV-ozone treatment.


**Patentansprüche**

1. Fotoelektrode (20, 220) für eine farbstoffsensibilisierte Solarzelle (1, 201), mit:

einem Sensibilisator, der in einer funktionalen Halbleiterschicht (23a), einer Fotoelektrodenstruktur (20K), die mit der funktionalen Halbleiterschicht (23a) auf einer transparenten leitfähigen Schicht (21b) eines durchscheinenden Substrats (21) oder auf einem metallischen Substrat (221) bereitgestellt ist, getragen wird, wobei das durchscheinende Substrat (21) durch Bilden der transparenten leitfähigen Schicht (21b) auf einem durchscheinenden Plastikträger (21a) gemacht ist,

wobei die funktionale Halbleiterschicht (23a) eine rollengepresste Schicht in Kontakt mit der transparenten leitfähigen Schicht (21b) oder dem Metallsubstrat (221) enthält und wobei sich Spuren des Rollenpressens parallel mit einer Rollenpressbehandlungsrichtung auf einer Oberfläche der rollengepressten Schicht erstrecken, und

eine Oberflächenrauheit Ra in einer ersten Richtung, die parallel mit der Rollenpressbehandlungsrichtung ist, kleiner als eine Oberflächenrauheit Ra in einer zweiten Richtung, die senkrecht zu der ersten Richtung auf einer Oberfläche der funktionalen Halbleiterschicht (23a) ist, ist, und die Oberflächenrauheit in der zweiten Richtung größer als oder gleich 1,2 Mal der Oberflächenrauheit Ra in der ersten Richtung ist.

2. Fotoelektrode (20, 220) für eine farbstoffsensibilisierte Solarzelle (1, 201) nach Anspruch 1, wobei eine Lichttransmittanz eines Laminats, das aus dem durchscheinenden Substrat (21) und der rollengepressten Schicht der funktionalen Halbleiterschicht (23a) in der Fotoelektrodenstruktur gemacht ist, bei einer Wellenlänge von 500 nm 20% bis 85% ist und eine Lichttransmittanz des Laminats bei einer Wellenlänge von 700 nm 30% bis 85% ist.

3. Fotoelektrode (20, 220) für eine farbstoffsensibilisierte Solarzelle (1, 201) nach Anspruch 1, wobei eine Dicke der rollengepressten Schicht der funktionalen Halbleiterschicht (23a) innerhalb von 1 $\mu$m bis 40 $\mu$m ist.

4. Fotoelektrode (20, 220) für eine farbstoffsensibilisierte Solarzelle (1, 201) nach einem der Ansprüche 1 bis 3, wobei die funktionale Halbleiterschicht (23a) Partikel enthält, die einen durchschnittlichen Partikeldurchmesser von 2 nm bis 40 nm haben.

5. Fotoelektrode (20, 220) für eine farbstoffsensibilisierte Solarzelle (1, 201) nach einem der Ansprüche 1 bis 4, wobei die funktionale Halbleiterschicht (23a) zwei oder mehrere Arten von Partikeln mit verschiedenen durchschnittlichen Partikeldurchmessern enthält, und der durchschnittliche Partikeldurchmesser von zumindest einer Art der Partikel ist 2 nm bis 40 nm.

6. Fotoelektrode (20, 220) für eine farbstoffsensibilisierte Solarzelle (1, 201) nach Anspruch 5, wobei in den zwei oder mehr Arten von Partikeln mit verschiedenen durchschnittlichen Partikeldurchmessern ein Inhaltsverhältnis von Partikeln mit einem durchschnittlichen Partikeldurchmesser von 2 nm bis 40 nm 50 Massenprozent bis 95 Massenprozent ist.

7. Farbstoffsensibilisierte Solarzelle (1, 201) mit:

der Fotoelektrode (20, 220) für eine farbstoffsensibilisierte Solarzelle (1, 201) nach einem der Ansprüche 1 bis 6, wobei die Fotoelektrode (20, 220) für eine farbstoffsensibilisierte Solarzelle (1, 201) so bereitgestellt ist, dass sie einer Gegenelektrode (16, 216) über einen Elektrolytabschnitt (12) zugewandt ist.

8. Verfahren zum Herstellen einer Fotoelektrode (20, 220) für eine farbstoffsensibilisierte Solarzelle (1), die durch Schichten einer fotoelektrischen Umwandlungsschicht (23) auf einer transparenten leitfähigen Schicht (21b) eines durchscheinenden Substrats (21) oder auf einem Metallsubstrat (221) gebildet ist, wobei das durchscheinende Substrat (21) durch Bilden der transparenten leitfähigen Schicht (21b) auf einem durchscheinenden Plastikträger (21a) produziert ist, die fotoelektrische Umwandlungsschicht (23) Partikel und einen Sensibilisator enthält, und wobei das Verfahren aufweist:

Bilden einer gestrichenen Schicht (23A) durch Anbringen einer Paste, die die Partikel enthält, auf die transparente leitfähige Schicht (21b) oder das Metallsubstrat (221), und dann Rollenpressen der gestrichenen Schicht (23A) unter einem Druck von $5 \times 10^6$ Pa (5 MPa) bis $5 \times 10^8$ Pa (500 MPa); Ermöglichen einer Schicht, die durch Rollenpressen der gestrichenen Schicht erhalten wird, den Sensibilisator zu tragen; und Bilden von Rollenpressspuren mit verschiedenen Oberflächenrauheiten Ra auf einer Oberfläche der gestrichenen Schicht (23A) in einer ersten Richtung und einer zweiten Richtung, wobei die erste Richtung parallel mit einer Rollenpressbehandlungsrichtung ist, die zweite Richtung senkrecht zu der ersten Richtung ist, wenn die gestrichene Schicht (23A) rollengepresst wird, die Oberflächenrauheit Ra in der zweiten Richtung größer oder gleich 1,2 Mal die Oberflächenrauheit Ra in der ersten Richtung ist.

9. Verfahren zum Herstellen einer Fotoelektrode (20, 220) für eine farbstoffsensibilisierte Solarzelle (1, 201) nach Anspruch 8, wobei in dem durchscheinenden Substrat (21) eine Oberfläche der transparenten leitfähigen Schicht (21b) einer UV-Ozonbehandlung unterzogen wird.

## Revendications

1. Photoélectrode (20, 220) pour une cellule solaire à colorant (1, 201), comprenant :

un sensibilisant supporté dans une couche semi-conductrice fonctionnelle (23a) d'une structure de photoélectrode (20K) dotée de la couche semi-conductrice fonctionnelle (23a) sur une couche conductrice transparente (21b) d'un substrat translucide (21) ou sur un substrat métallique (221), le substrat translucide (21) étant obtenu par formation de la couche conductrice transparente (21b) sur un support translucide plastique (21a), dans laquelle la couche semi-conductrice fonctionnelle (23a) comprend une couche pressée au rouleau en contact avec la couche conductrice transparente (21b) ou le substrat métallique (221) et des traces de pressage au rouleau s'étendant parallèlement à la direction de traitement par pressage au rouleau sur une surface de la couche pressée au rouleau, et la rugosité de surface Ra dans une première direction qui est parallèle à la direction de pressage au rouleau est inférieure à la rugosité de surface Ra dans une deuxième direction qui est orthogonale à la première direction sur une surface de la couche semi-conductrice fonctionnelle (23a), et la rugosité de surface Ra dans la deuxième direction est supérieure ou égale à 1,2 fois la rugosité de surface Ra dans la première direction.

2. Photoélectrode (20, 220) pour une cellule solaire à colorant (1, 201) selon la revendication 1, dans laquelle le coefficient de transmission lumineuse d'un stratifié fait du substrat translucide (21) et de la couche pressée au rouleau de la couche semi-conductrice fonctionnelle (23a) dans la structure de photoélectrode à une longueur d'onde de 500 nm est de 20 % à 85 %, et le coefficient de transmission lumineuse du stratifié à une longueur d'onde de 700 nm est de 30 % à 85 %.

3. Photoélectrode (20, 220) pour une cellule solaire à colorant (1, 201) selon la revendication 1, dans laquelle l'épaisseur de la couche pressée au rouleau de la couche semi-conductrice fonctionnelle (23a) est située dans la plage allant de 1 $\mu$m à 40 $\mu$m.

4. Photoélectrode (20, 220) pour une cellule solaire à colorant (1, 201) selon l'une quelconque des revendications 1 à 3, dans laquelle la couche semi-conductrice fonctionnelle (23a) contient des particules ayant une granulométrie moyenne de 2 nm à 40 nm.

5. Photoélectrode (20, 220) pour une cellule solaire à colorant (1, 201) selon l'une quelconque des revendications 1 à 4, dans laquelle la couche semi-conductrice fonctionnelle (23a) contient deux types ou plus de particules ayant des granulométries moyennes différentes, et la granulométrie moyenne d'au moins un type de particules est de 2 nm à 40 nm.

6. Photoélectrode (20, 220) pour une cellule solaire à colorant (1, 201) selon la revendication 5, dans laquelle, dans les deux types ou plus de particules ayant des granulométries moyennes différentes, la proportion contenue des particules ayant une granulométrie moyenne de 2 nm à 40 nm est de 50 % en masse à 95 % en masse.

7. Cellule solaire à colorant (1, 201) comprenant :

la photoélectrode (20, 220) pour une cellule solaire à colorant (1, 201) selon l'une quelconque des revendications 1 à 6,
dans laquelle la photoélectrode (20, 220) pour une cellule solaire à colorant (1, 201) est disposée de façon à faire face à une contre-électrode (16, 216) à travers une partie d'électrolyte (12).

8. Procédé pour fabriquer une photoélectrode (20, 220) pour une cellule solaire à colorant (1) formée par stratification d'une couche de conversion photoélectrique (23) sur une couche conductrice transparence (21b) d'un substrat translucide (21) ou sur un substrat métallique (221), le substrat translucide (21) étant produit par formation de la couche conductrice transparente (21b) sur un support translucide plastique (21a), la couche de conversion photoélectrique (23) contenant des particules et un sensibilisant,
le procédé comprenant :

la formation d'un film déposé sous forme de revêtement (23A) par application d'une pâte contenant les particules à la couche conductrice transparente (21b) ou au substrat métallique (221), et ensuite le pressage au rouleau du film déposé sous forme de revêtement (23A) sous une pression de $5 \times 10^6$ Pa (5 MPa) à $5 \times 10^8$ Pa (500 MPa) ; l'opération consistant à laisser une couche obtenue par pressage au rouleau du film déposé sous forme de revêtement supporter le sensibilisant ; et
la formation de traces de pressage au rouleau ayant différentes rugosités de surface Ra sur une surface du film déposé sous forme de revêtement (23A) dans une première direction et une deuxième direction, la première direction étant parallèle à la direction de traitement de pressage au rouleau, la deuxième direction étant orthogonale à la première direction lors du pressage au rouleau du film déposé sous forme de revêtement (23A), la rugosité de surface Ra dans la deuxième direction étant supérieure ou égale à 1,2 fois la rugosité de surface Ra dans la première direction.

9. Procédé pour fabriquer une photoélectrode (20, 220) pour une cellule solaire à colorant (1, 201) selon la revendication 8, dans lequel, dans le substrat translucide (21), une surface de la couche conductrice transparente (21b) est soumise à un traitement aux UV-ozone.

# FIG. 1

# FIG. 2A

# FIG. 2B

# FIG. 2C

# FIG. 2D

# FIG. 3

# FIG. 4A

21b
21
21a

# FIG. 4B

123p
21b
21
21a

# FIG. 4C

123α
21b
21
21a

# FIG. 4D

123q
123 α
21b
21
21a

# FIG. 4E

20L
123 β
123 α
21b
21
21a

# FIG. 4F

120
123B
123A } 123
21b
21
21a

# FIG. 5

# FIG. 6

# FIG. 7

1 μm

← ROLL-PRESSING TREATMENT DIRECTION

# FIG. 8

1 μm

# FIG. 9

300

3 μm ——310

4 μm ——320

3 μm ——330

ROLL-PRESSING TREATMENT DIRECTION →

# FIG. 10

3 μm | 4 μm | 3 μm

300

410　　420　　430

ROLL-PRESSING TREATMENT DIRECTION →

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007100095 A
- JP 2011142010 A
- WO 2010008294 A1

**Non-patent literature cited in the description**

- *Nature,* 1991, vol. 353, 737-740
- *SOL. Energy Mater. Sol. Cel.,* 2010, vol. 94 (812
- **HENRIK LINDSTRÖM et al.** A New Method for Manufacturing Nanostructured Electrodes on Plastic Substrates. *Nano Letters,* 07 January 2001, vol. 1 (2), 97-100
- **FRANCK PLOURABOUÉ et al.** Multi-scale roughness transfer in cold metal rolling. *Tribology International,* 01 January 1999, vol. 32 (1), 45-57
- Dynamic preparation of TiO2 films for fabrication of dye-sensitized solar cells. **SANTA-NOKKI H et al.** JOURNAL OF PHOTOCHEMISTRY AND PHOTOBIOLOGY, A: CHEMISTRY. ELSEVIER SEQUOIA, 31 August 2006, vol. 182, 187-191
- Preparation of TiO2/dye composite particles and their applications in dye-sensitized solar cell. **CHOU C S et al.** POWDER TECHNOLOGY. ELSEVIER SEQUOIA, 28 October 2008, vol. 187, 181-189